# EUROPEAN PATENT APPLICATION

(11) **EP 4 350 735 A1**
(43) Date of publication of application: **10.04.2024**
(21) Application number: 21960256.2
(22) Date of filing: 14.10.2021

(54) **DISPLAY PANEL AND DISPLAY DEVICE**

(71) Applicant: BOE Technology Group Co., Ltd., Chaoyang District, Beijing 100015 (CN); Chengdu BOE Optoelectronics Technology Co., Ltd., Chengdu, Sichuan 611731 (CN)
(72) Inventor: CHEN, Jiaxing, Beijing 100176 (CN); ZHANG, Bo, Beijing 100176 (CN); LIU, Biao, Beijing 100176 (CN); NIU, Zuoji, Beijing 100176 (CN); XU, Yang, Beijing 100176 (CN); LONG, Yixuan, Beijing 100176 (CN); SHANG, Tinghua, Beijing 100176 (CN)
(74) Representative: Hoffmann Eitle
(86) International application number: PCT/CN2021/123928
(87) International publication number: WO 2023/060520

(57) **Abstract**

A display panel (100), comprising a substrate (1), a circuit structure layer (2), a first electrode layer (3) and a pixel defining layer (6) that are stacked in sequence. The circuit structure layer (2) comprises a plurality of pixel driving circuits (21), the first electrode layer (3) comprises a plurality of first electrodes (31), and the first electrodes (31) are electrically connected to the pixel driving circuits (21). The pixel defining layer (6) has a plurality of pixel openings (61), and the pixel openings (61) expose at least part of the first electrodes (31). The orthographic projection of at least one first electrode (31) on the substrate (1) at least partially overlaps with the orthographic projection of the gate, on the substrate (1), of a data compensation transistor (T2) in a pixel driving circuit (21) corresponding to a first electrode (31) and simultaneously at least partially overlaps with the orthographic projection of the gate, on the substrate (1), of the data compensation transistor (T2) in at least one pixel driving circuit (21) adjacent to a pixel driving circuit (21) corresponding to a first electrode (31). The orthographic projection of a pixel opening (61), on the substrate, corresponding to at least one first electrode (31) (1) is separated from the orthographic projection of the gate, on the substrate (1), of the data compensation transistor (T2) in a pixel driving circuit (21) corresponding to a first electrode (31).

## Description

### TECHNICAL FIELD

The present disclosure relates to the field of display technologies, and in particular, to a display panel and a display apparatus.

### BACKGROUND

Organic light-emitting diode (OLED) display panels have gradually become the mainstream in the display field due to their excellent performance of low power consumption, high color saturation, wide viewing angle, small thickness, capability to achieve flexibility, and the like.

### SUMMARY

In an aspect, a display panel is provided. The display panel includes a substrate, a circuit structure layer, a first electrode layer and a pixel definition layer. The circuit structure layer is located on a side of the substrate, and the circuit structure layer includes a plurality of pixel driving circuits; the plurality of pixel driving circuits are arranged in a first direction to constitute pixel driving circuit rows, and the pixel driving circuit rows are sequentially arranged in a second direction; the first direction intersects the second direction. The first electrode layer is located on a side of the circuit structure layer away from the substrate, the first electrode layer includes a plurality of first electrodes, and a first electrode is electrically connected to a pixel driving circuit. The pixel definition layer is located on a side of the first electrode layer away from the substrate, the pixel definition layer has a plurality of pixel openings therein, and a pixel opening exposes at least a portion of a respective first electrode. The pixel driving circuits each include a driving transistor and a data compensation transistor. An orthographic projection of at least one first electrode on the substrate at least partially overlaps with both of an orthographic projection, on the substrate, of a gate of a data compensation transistor in a pixel driving circuit corresponding to the first electrode and an orthographic projection, on the substrate, of a gate of a data compensation transistor in at least one pixel driving circuit adjacent to the pixel driving circuit corresponding to the first electrode; an orthogonal projection, on the substrate, of a pixel opening corresponding to the at least one first electrode is spaced apart from the orthographic projection, on the substrate, of the gate of the data compensation transistor in the pixel driving circuit corresponding to the first electrode. For a first electrode of the at least one first electrode, an orthographic projection, on the substrate, of the data compensation transistor corresponding to the first electrode and a first virtual straight line extending in the first direction have a first overlapping portion; an orthographic projection, on the substrate, of a data compensation transistor in a pixel driving circuit adjacent to a pixel driving circuit corresponding to the first electrode and the first virtual straight line have a second overlapping portion; a distance, in the first direction, between the first overlapping portion and the second overlapping portion is greater than a dimension, in the first direction, of a pixel opening corresponding to the first overlapping portion.

In some embodiments, the plurality of pixel openings are arranged in a plurality of rows and a plurality of columns, and two adjacent rows of pixel openings are staggered from one another in the first direction. In two adjacent rows of pixel openings, a row of pixel openings include first pixel openings and second pixel openings that are alternately arranged in the first direction, and another row of pixel openings include third pixel openings sequentially arranged in the first direction. In two adjacent columns of pixel openings, a column of pixel openings include first pixel openings and second pixel openings that are alternately arranged in the second direction, and another column of pixel openings include third pixel openings sequentially arranged in the second direction. An area of a first pixel opening is less than an area of a second pixel opening, and the area of the first pixel opening is greater than an area of a third pixel opening.

In some embodiments, in any row of pixel openings including first pixel openings and second pixel openings that are alternately arranged, any first pixel opening has an equal distance to two second pixel openings adjacent to the any first pixel opening. In any column of pixel openings including first pixel openings and second pixel openings that are alternately arranged, any first pixel opening has distances, that are not equal, to two second pixel openings adjacent to the any first pixel opening, respectively.

In some embodiments, geometrical centers of a first pixel opening and a second pixel opening that are adjacent to each other in a column of pixel openings, and geometrical centers of a first pixel opening and a second pixel opening that are adjacent to each other in an adjacent column of pixel openings are sequentially connected to form a virtual trapezoid.

In some embodiments, in a same row of pixel openings, a center of a first pixel opening and a center of a second pixel opening have a distance in the second direction therebetween.

In some embodiments, the distance is less than or equal to half of a dimension of the first pixel opening in the second direction.

In some embodiments, an orthographic projection, on the substrate, of a first electrode corresponding to the first pixel opening at least partially overlaps with both of an orthographic projection, on the substrate, of a gate of a data compensation transistor in a pixel driving circuit corresponding to the first electrode, and an orthographic projection, on the substrate, of a gate of a data compensation transistor in at least one pixel driving circuit adjacent to the pixel driving circuit corresponding to the first electrode; and/or an orthographic projection, on the substrate, of a first electrode corresponding to the second pixel opening at least partially overlaps with both of an orthographic projection, on the substrate, of a gate of a data compensation transistor in a pixel driving circuit corresponding to the first electrode, and an orthographic projection, on the substrate, of a gate of a data compensation transistor in at least one pixel driving circuit adjacent to the pixel driving circuit corresponding to the first electrode.

In some embodiments, an orthogonal projection of the first pixel opening on the substrate is spaced apart from an orthographic projection, on the substrate, of a gate of a data compensation transistor in a pixel driving circuit corresponding to the first pixel opening; and/or an orthogonal projection of the third pixel opening on the substrate is spaced apart from an orthographic projection, on the substrate, of a gate of a data compensation transistor in a pixel driving circuit corresponding to the third pixel opening.

In some embodiments, first pixel openings and third pixel openings are alternately arranged in a third direction to constitute first groups of pixel openings, second pixel openings and third pixel openings are alternately arranged in the third direction to constitute second groups of pixel openings, and the first groups of pixel openings and the second groups of pixel openings are alternately arranged in a fourth direction; the third direction intersects the fourth direction. In a first group of pixel openings, an orthographic projection, on the substrate, of a first electrode corresponding to a first pixel opening at least partially overlaps with an orthographic projection, on the substrate, of a gate of a data compensation transistor in a pixel driving circuit corresponding to a third pixel opening adjacent to the first pixel opening. In a second group of pixel openings, an orthographic projection, on the substrate, of a first electrode corresponding to a second pixel opening at least partially overlaps with an orthographic projection, on the substrate, of a gate of a data compensation transistor corresponding to another third pixel opening adjacent to the second pixel opening.

In some embodiments, orthographic projections, on the substrate, of two first electrodes respectively corresponding to a first pixel opening and a second pixel opening that are adjacent to each other at least partially overlap with orthographic projections, on the substrate, of gates of data compensation transistors respectively corresponding to two third pixel openings that are located on a same side of the first pixel opening and the second pixel opening that are adjacent to each other, respectively.

In some embodiments, the display panel has a display region; pixel openings closest to a border of the display region includes at least one row of pixel openings including first pixel openings and second pixel openings that are alternately arranged in the first direction and/or at least one column of pixel openings including first pixel openings and second pixel openings that are alternately arranged in the second direction.

In some embodiments, the first pixel opening is configured to define an effective light-emitting region of first-color light, the second pixel opening is configured to define an effective light-emitting region of second-color light, and the third pixel opening is configured to define an effective light-emitting region of third-color light. The first-color light is red light, the second-color light is blue light, and the third-color light is green light.

In some embodiments, the circuit structure layer includes an active layer, a first gate layer, a second gate layer and a source-drain electrode layer that are sequentially away from the substrate. The display panel further includes a conductive connection layer located between the circuit structure layer and the first electrode layer. The display panel includes a plurality of reset signal lines for providing reset signals for the first electrodes. The plurality of reset signal lines include first reset signal lines located in the second gate layer and extending in the first direction; and second reset signal lines located in the source-drain electrode layer or the conductive connection layer and extending in the second direction. An orthographic projection of a first reset signal line on the substrate overlaps with an orthographic projection of the second reset signal line on the substrate, and at a position where the orthographic projection of the first reset signal line on the substrate overlaps with the orthographic projection of the second reset signal line on the substrate, the first reset signal line is electrically connected to the second reset signal line through a via hole. In a case where the first reset signal line is located in the second gate layer and the second reset signal line is located in the source-drain electrode layer, the second reset signal line is connected to the active layer through another via hole.

In some embodiments, the display panel further includes a plurality of power supply signal lines. The plurality of power supply signal lines include a first power supply signal line located in the source-drain electrode layer and extending in the second direction, and a second power supply signal line located in the conductive connection layer and extending in the second direction. The first power supply signal line is electrically connected to the second power supply signal line, an orthographic projection of the first power supply signal line on the substrate overlaps with an orthographic projection of the second power supply signal line on the substrate, and an orthogonal projection of at least one pixel opening on the substrate is located within the orthographic projection of the second power supply signal line on the substrate.

In some embodiments, the second power supply signal line has a plurality of protruding portions, and an orthographic projection of a protruding portion on the substrate at least partially overlaps with an orthogonal projection, on the substrate, of the pixel opening corresponding to the respective first electrode.

In some embodiments, the display panel further includes a plurality of data signal lines located in the conductive connection layer and extending in the second direction, and the plurality of data signal lines are sequentially arranged in the first direction. The first pixel opening, the second pixel opening and the third pixel opening are configured to be arranged in at least one of following manners: an orthogonal projection of the first pixel opening on the substrate is located between orthographic projections of two adjacent data signal lines on the substrate; or an orthogonal projection of the second pixel opening on the substrate is located between an orthographic projection of another two adjacent data signal lines on the substrate; or the orthographic projections of the another two adjacent data signal lines on the substrate each partially overlap with the orthogonal projection of the second pixel opening on the substrate, and an area of an overlapping portion of an orthographic projection of one of the another two adjacent data signal lines on the substrate and the orthogonal projection of the second pixel opening on the substrate is approximately equal to an area of an overlapping portion of an orthographic projection of another of the another two adjacent data signal lines on the substrate and the orthogonal projection of the second pixel opening on the substrate; or an orthogonal projection of the third pixel opening on the substrate is located between orthographic projections of yet another two adjacent data signal lines on the substrate.

In some embodiments, the first pixel opening, the second pixel opening and the third pixel opening are configured to be arranged in at least one of following ways: a plane of symmetry of the two adjacent data signal lines is taken as a plane of symmetry, the first pixel opening is mirror-symmetric; or another plane of symmetry of the another two adjacent data signal lines is taken as another plane of symmetry, the second pixel opening is mirror-symmetric; or yet another plane of symmetry of the yet another two adjacent data signal lines is taken as yet another plane of symmetry, the third pixel opening is mirror-symmetric.

In some embodiments, the display panel further includes a first planarization layer, a conductive connection layer and a second planarization layer that are located between the circuit structure layer and the first electrode layer and sequentially away from the substrate. The first planarization layer has a plurality of first via holes therein, the conductive connection layer includes a plurality of conductive portions, and the second planarization layer has a plurality of second via holes therein. The display panel has a plurality of sub-pixel regions. In a sub-pixel region, a first electrode is electrically connected to a conductive portion through a second via hole, and the conductive portion is electrically connected to a pixel driving circuit through a first via hole; and a minimum distance between an orthogonal projection of a border of the first via hole on the substrate and an orthogonal projection of a pixel opening on the substrate is less than a minimum distance between an orthogonal projection of a border of the second via hole on the substrate and the orthogonal projection of the pixel opening on the substrate.

In some embodiments, in the two adjacent rows of pixel openings, first via holes respectively corresponding to all pixel openings are arranged on a straight line extending in the first direction, and second via holes respectively corresponding to all the pixel openings are alternately arranged, in the first direction, on both sides of the straight line extending in the first direction.

In some embodiments, in the two adjacent rows of pixel openings, the first via holes respectively corresponding to all the pixel openings are each located at a same position in a respective pixel driving circuit; and the second via holes respectively corresponding to the first pixel openings and second via holes respectively corresponding to the second pixel openings are each located at a same position in a respective pixel driving circuit.

In some embodiments, in the two adjacent rows of pixel openings, positions of the first via holes respectively corresponding to all the pixel openings are different in the second direction. The display panel further includes light-emitting control signal lines located in a first gate layer and extending in the first direction, and an orthogonal projection of each first via hole on the substrate has an approximately equal overlapping area with an orthographic projection of a respective light-emitting control signal line on the substrate.

In some embodiments, in a same column of pixel openings, first via holes respectively corresponding to all the pixel openings and second via holes respectively corresponding to all pixel openings are arranged on a straight line extending in the second direction.

In another aspect, a display apparatus is provided. The display apparatus includes the display panel as described in any one of the above embodiments.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art can obtain other drawings according to these drawings. In addition, the accompanying drawings in the following description may be regarded as schematic diagrams, and are not limitations on actual sizes of products, actual processes of methods and actual timings of signals involved in the embodiments of the present disclosure.
FIG. 1 is a diagram showing a structure of a display apparatus, in accordance with some embodiments of the present disclosure;
FIG. 2 is a diagram showing a structure of a display panel, in accordance with some embodiments of the present disclosure;
FIG. 3 is a sectional view taken along the line A-A' in FIG. 2;
FIG. 4 is a diagram showing a structure of another display panel, in accordance with some embodiments of the present disclosure;
FIG. 5A is a diagram showing a structure of yet another display panel, in accordance with some embodiments of the present disclosure;
FIG. 5B is a diagram showing a positional relationship of a source-drain metal layer, a conductive connection layer and a first electrode layer in a sub-pixel region, in accordance with some embodiments of the present disclosure;
FIG. 6A is a diagram showing a positional relationship of an active layer and a first gate layer in a sub-pixel region in FIG. 5A;
FIG. 6B is a diagram showing another positional relationship of an active layer and a first gate layer in a sub-pixel region, in accordance with some embodiments of the present disclosure;
FIG. 6C is a diagram showing yet another positional relationship of an active layer and a first gate layer in a sub-pixel region, in accordance with some embodiments of the present disclosure;
FIG. 6D is a diagram showing a positional relationship of an active layer and a first gate layer in two sub-pixel regions in FIG. 5A;
FIG. 7 is an equivalent circuit diagram of a sub-pixel region in FIG. 5A;
FIG. 8A is a diagram showing a positional relationship of an active layer, a first gate layer and a second gate layer in a sub-pixel region in FIG. 5A;
FIG. 8B is a diagram showing a positional relationship of an active layer, a first gate layer, a second gate layer, a source-drain metal layer and a conductive connection layer in a sub-pixel region, in accordance with some embodiments of the present disclosure;
FIG. 8C is a diagram showing another positional relationship of an active layer, a first gate layer, a second gate layer, a source-drain metal layer and a conductive connection layer in a sub-pixel region, in accordance with some embodiments of the present disclosure;
FIG. 9 is a diagram showing a positional relationship of an active layer, a first gate layer, a second gate layer and a source-drain metal layer in FIG. 5A;
FIG. 10 is a diagram showing a positional relationship of an active layer, a first gate layer, a second gate layer, a source-drain metal layer and a conductive connection layer in FIG. 5A;
FIG. 11 is a diagram of an arrangement of pixel openings, in accordance with some embodiments of the present disclosure;
FIG. 12 is another diagram of an arrangement of pixel openings, in accordance with some embodiments of the present disclosure;
FIG. 13 is yet another diagram of an arrangement of pixel openings, in accordance with some embodiments of the present disclosure;
FIG. 14 is yet another diagram of an arrangement of pixel openings, in accordance with some embodiments of the present disclosure;
FIG. 15 is yet another diagram of an arrangement of pixel openings, in accordance with some embodiments of the present disclosure;
FIG. 16 is yet another diagram of an arrangement of pixel openings, in accordance with some embodiments of the present disclosure;
FIG. 17 is a diagram showing a structure of yet another display panel, in accordance with some embodiments of the present disclosure;
FIG. 18 is another sectional view taken along the line A-A' in FIG. 2;
FIG. 19A is a diagram showing a positional relationship of pixel openings, first via holes and second via holes, in accordance with some embodiments of the present disclosure;
FIG. 19B is a diagram showing another positional relationship of pixel openings, first via holes and second via holes, in accordance with some embodiments of the present disclosure; and
FIG. 19C is a diagram showing yet another positional relationship of pixel openings, first via holes and second via holes, in accordance with some embodiments of the present disclosure.

### DETAILED DESCRIPTION

Technical solutions in some embodiments of the present disclosure will be described clearly and completely below with reference to the accompanying drawings. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials or characteristics may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a plurality of" or "the plurality of" means two or more unless otherwise specified.

In the description of some embodiments, the terms such as "coupled" and "connected" and derivatives thereof may be used. For example, the term "connected" may be used in the description of some embodiments to indicate that two or more components are in direct physical or electrical contact with each other. For another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

The phrase "applicable to" or "configured to" as used herein indicates an open and inclusive expression, which does not exclude devices that are applicable to or configured to perform additional tasks or steps.

Additionally, the phase "based on" as used herein is meant to be open and inclusive, since a process, a step, a calculation or other action that is "based on" one or more of the stated conditions or values may, in practice, be based on additional conditions or values beyond those stated.

As used herein, the term such as "about", "substantially" or "approximately" includes a stated value and an average value within an acceptable range of deviation of a particular value. The acceptable range of deviation is determined by a person of ordinary skill in the art in view of measurement in question and errors associated with measurement of a particular quantity (i.e., limitations of a measurement system).

As used herein, the term such as "parallel", "perpendicular" or "equal" includes a stated condition and a condition similar to the stated condition, a range of the similar condition is within an acceptable range of deviation, and the acceptable range of deviation is determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be that, for example, a difference between the two that are equal is less than or equal to 5% of either of the two.

Exemplary embodiments are described herein with reference to sectional views and/or plan views as idealized exemplary drawings. In the accompanying drawings, thicknesses of layers and sizes of regions are enlarged for clarity. Thus, variations in shape relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown in a rectangular shape generally has a feature of being curved. Therefore, the regions shown in the accompanying drawings are schematic in nature, and their shapes are not intended to show actual shapes of regions in a device, and are not intended to limit the scope of the exemplary embodiments.

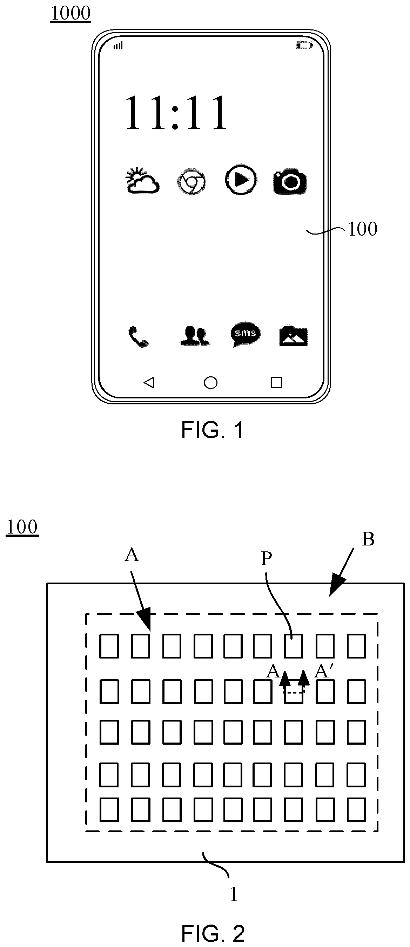

Some embodiments of the present disclosure provide a display apparatus 1000, referring to FIG. 1, the display apparatus 1000 includes a display panel 100.

It will be noted that the type of the display apparatus 1000 varies. The display apparatus 1000 may be, for example, an organic light-emitting diode (OLED) display apparatus, a quantum dot light emitting diodes (QLED) display apparatus or a light-emitting diode (LED) display apparatus. The OLED display apparatus may include, for example, an active-matrix organic light-emitting diode (AMOLED) display apparatus.

The product form of the display apparatus 1000 varies, which may be, for example, any apparatus that displays text or images whether in motion (e.g., a video) or stationary (e.g., a still image). More specifically, the display apparatus 1000 may be provided in a variety of electronic apparatuses or associated with a variety of electronic apparatuses. The variety of electronic apparatuses may be, but are not limited to, mobile phones, wireless apparatuses, personal digital assistants (PDAs), hand-held or portable computers, global positioning system (GPS) receivers/navigators, cameras, moving picture experts group 4 (MP4) video players, video cameras, game consoles, watches, clocks, calculators, television monitors, flat-panel displays, computer monitors, automobile displays (e.g., odometer displays), navigators, cockpit controllers and/or displays, camera view displays (e.g., displays of rear-view cameras in vehicles), electronic photos, electronic billboards or signs, projectors, building structures, packaging and aesthetic structures (e.g., displays for displaying an image of a piece of jewelry), etc.

Referring to FIG. 2, some embodiments of the present disclosure provide a display panel 100, and the display panel 100 may be applied to the display apparatus 1000. Of course, the display panel 100 may be applied to other apparatuses.

In some examples, referring to FIG. 2, the display panel 100 has a display region A located inside a dashed box and a peripheral region B located outside the dashed box. A portion of the display panel 100 located in the display region A can display images.

It will be noted that the present disclosure does not limit the setting position of the peripheral region B. For example, the peripheral region B may be located on a side, two sides or three sides of the display region A. For another example, the peripheral region B may be located around the display region A in a circle.

The type of the display panel 100 may vary, which may be, for example, an OLED display panel, a QLED display panel or an LED display panel. The OLED display panel may include, for example, an AMOLED display panel.

In some examples, with continued reference to FIG. 2, the display panel 100 has a plurality of sub-pixel regions P.

For example, the plurality of sub-pixel regions P are located in the display region A.

In some embodiments, referring to FIGS. 2 to 4, the display panel 100 includes a substrate 1.

In some examples, the substrate 1 may be a rigid substrate. The rigid substrate may be, for example, a glass substrate or a polymethyl methacrylate (PMMA) substrate.

In some other examples, the substrate 1 may be a flexible substrate. The flexible substrate may be, for example, a polyethylene terephthalate (PET) substrate, a polyimide (PI) substrate or a polyethylene naphthalate two formic acid glycol ester (PEN) substrate.

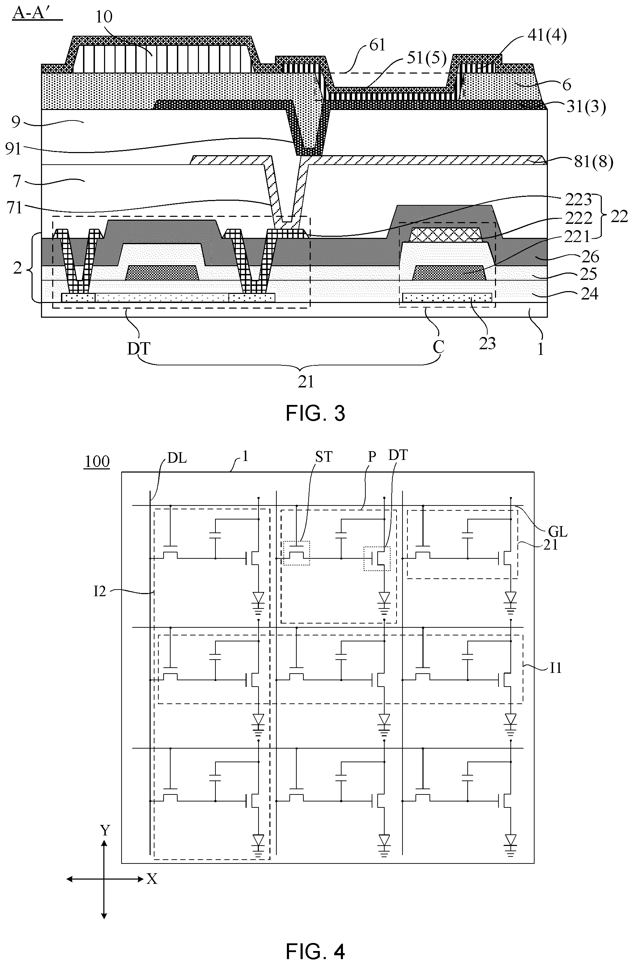

In some embodiments, referring to FIG. 3, the display panel 100 further includes a circuit structure layer 2 and a first electrode layer 3 that are located on a side of the substrate 1 and sequentially away from the substrate 1. The circuit structure layer 2 includes a plurality of pixel driving circuits 21, the first electrode layer 3 includes a plurality of first electrodes 31, and a first electrode 31 is electrically connected to a pixel driving circuit 21.

In some examples, the first electrode 31 is directly electrically connected to the pixel driving circuit 21.

For example, the display panel 100 further includes a planarization layer located between the circuit structure layer 2 and the first electrode layer 3, the planarization layer has a plurality of via holes therein, and the first electrode 31 is electrically connected to the pixel driving circuit 21 through a via hole.

In some other examples, with continued reference to FIG. 3, the display panel 100 further includes a conductive connection layer 8 located between the circuit structure layer 2 and the first electrode layer 3, the conductive connection layer 8 includes a plurality of conductive portions 81, and the first electrode 31 is indirectly electrically connected to the pixel driving circuit 21 through a conductive portion 81.

For example, with continued reference to FIG. 3, the display panel 100 further includes a first planarization layer 7 and a second planarization layer 9. The first planarization layer 7 is located between the circuit structure layer 2 and the conductive connection layer 8, and the first planarization layer 7 has a plurality of first via holes 71 therein. The second planarization layer 9 is located between the conductive connection layer 8 and the first electrode layer 3, and the second planarization layer 9 has a plurality of second via holes 91 therein. The conductive portion 81 is electrically connected to the pixel driving circuit 21 through a first via hole 71, and the first electrode 31 is electrically connected to the conductive portion 81 through a second via hole 91.

In some examples, referring to FIG. 4, the display panel 100 further includes a plurality of gate lines GL and a plurality of data signal lines DL. The plurality of gate lines GL each extend in the first direction X, and the plurality of gate lines GL are sequentially arranged in the second direction Y The plurality of data signal lines DL each extend in the second direction Y, and the plurality of data signal lines DL are sequentially arranged in the first direction X.

For example, the plurality of data signal lines DL are located on a side of the plurality of gate lines GL away from the substrate 1, and the plurality of data signal lines DL and the plurality of gate lines GL are insulated from each other.

For example, in a case where the display panel 100 includes the conductive connection layer 8, the plurality of data signal lines DL are located in the conductive connection layer 8.

For example, in a case where the display panel 100 includes the circuit structure layer 2, the plurality of gate lines GL may be disposed in a same layer as at least one metal layer of the circuit structure layer 2.

It will be noted that, the "same layer" mentioned in some of the above examples refers to a layer structure formed through a same patterning process by using a same mask in which a film layer for forming specific patterns is formed by using a same film-forming process. Depending on different specific patterns, the same patterning process may include several exposure, development and etching, the specific patterns formed in the layer structure may be continuous or discontinuous, and these specific patterns may also be at different heights or have different thicknesses. In this way, in the same patterning process, it is possible to form the data signal lines DL and the conductive connection layer 8 synchronously, and it is also possible to form the gate lines GL and the at least one metal layer of the circuit structure layer 2 synchronously, so that it is conducive to simplifying a manufacturing process of the display panel 100.

In some examples, with continued reference to FIG. 4, the plurality of gate lines GL intersect the plurality of data signal lines DL to define the plurality of sub-pixel regions P, and the plurality of sub-pixel regions P are in a one-to-one correspondence with the plurality of pixel driving circuits 21.

For example, sub-pixel regions P arranged in a line in the first direction X may be referred to as a same row of sub-pixel regions P, and sub-pixel regions P arranged in a line in the second direction Y may be referred to as a same column of sub-pixel regions P.

On this basis, with continued reference to FIG. 4, the plurality of pixel driving circuits 21 are arranged in the first direction X to constitute pixel driving circuit rows 11, and the pixel driving circuit rows I1 are sequentially arranged in the second direction Y; the plurality of pixel driving circuits 21 are arranged in the second direction Y to constitute pixel driving circuit rows I2, and the pixel driving circuit rows I2 are sequentially arranged in the first direction X. The first direction X intersects the second direction Y (for example, the first direction X is perpendicular to the second direction Y).

For example, all pixel driving circuits 21 in a same pixel driving circuit row I1 may be electrically connected to a gate line GL, and all pixel driving circuits 21 in a same pixel driving circuit column I2 may be electrically connected to a data signal line DL. The gate line GL may provide a scan signal for the pixel driving circuits 21 in a same row electrically connected thereto, and the data signal line DL may provide a data signal for the pixel driving circuits 21 in a same column electrically connected thereto.

It will be easily understood that, all pixel driving circuits 21 in the same pixel driving circuit row I1 may be electrically connected to gate lines GL, which is not limited in the embodiments of the present disclosure.

In some examples, referring to FIG. 3, the display panel 100 further includes a light-emitting functional layer 4 and a second electrode layer 5 that are located on a side of the first electrode layer 3 away from the substrate 1 and sequentially away from the substrate 1. The light-emitting functional layer 4 includes a plurality of light-emitting portions 41, and the second electrode layer 5 includes a plurality of second electrodes 51. In a sub-pixel region P, a first electrode 31, a light-emitting portion 41 and a second electrode 51 constitute a light-emitting device. A pixel driving circuit 21 is electrically connected to a light-emitting device, and the pixel driving circuit 21 is configured to provide a driving voltage for a light-emitting device electrically connected thereto to control a light-emitting state of the light-emitting device.

It will be noted that the first electrode 31 may be an anode or a cathode. Correspondingly, the second electrode 51 may be a cathode or an anode. For example, the first electrode 31 is the anode, and the second electrode 51 is the cathode; in this case, the first electrode layer 3 constituted by the plurality of first electrodes 31 is an anode layer, and the second electrode layer 5 constituted by the plurality of second electrodes 51 is a cathode layer. For another example, the first electrode 31 is the cathode, and the second electrode 51 is the anode; in this case, the first electrode layer 3 constituted by the plurality of first electrodes 31 is a cathode layer, and the second electrode layer 5 constituted by the plurality of second electrodes 51 is an anode layer.

The second electrode layer 5 may be, for example, of an integral structure. The light-emitting functional layer 4 may be, for example, of an integral structure or a plurality of block structures.

The light-emitting device may be, for example, an OLED device or a OLEO device. An emission mode of the light-emitting device may be, for example, top emission.

In addition, all the plurality of light-emitting portions 41 constitute the light-emitting functional layer 4; the layered structure of the light-emitting functional layer 4 may vary, which may be set according to actual needs.

For example, the light-emitting functional layer 4 includes a light-emitting layer.

For example, the light-emitting functional layer 4 may further include a hole injection layer and/or a hole transporting layer disposed between the anode layer and the light-emitting layer.

For example, the light-emitting functional layer 4 may further include an electron transporting layer and/or an electron injection layer disposed between the light-emitting layer and the cathode layer.

It will be noted that the structure of the pixel driving circuit 21 varies, which may be set according to actual needs. For example, the structure of the pixel driving circuit 21 may include "2T1 C", "6T1 C", "7T1 C", "6T2C" or "7T2C". Here, "T" represents a thin film transistor, the number before the "T" represents the number of thin film transistors; "C" represents a storage capacitor C, and the number before the "C" represents the number of storage capacitors.

In some examples, referring to FIG. 4, the thin film transistors included in the pixel driving circuit 21 include a driving transistor DT and at least one switching transistor ST.

Here, the switching transistor ST refers to a thin film transistor, electrically connected to the gate line GL, in the thin film transistors included in the pixel driving circuit 21.

The driving transistor DT refers to a thin film transistor, electrically connected to the storage capacitor C, the switching transistor ST and the light-emitting device, in the thin film transistors included in the pixel driving circuit 21.

It will be noted that the driving transistor DT may be directly electrically connected to the light-emitting device (for example, as shown in FIG. 4), or may be indirectly electrically connected to the light-emitting device (for example, a switching transistor ST may be provided between the driving transistor DT and the light-emitting device).

For example, each thin film transistor included in the pixel driving circuit 21 may be, for example, a thin film transistor with a bottom-gate structure, or may be a thin film transistor with a top-gate structure.

In some embodiments, referring to FIG. 3, the display panel 100 further includes a pixel definition layer 6 located between the second electrode layer 5 and the light-emitting functional layer 4, and the pixel definition layer 6 includes a plurality of pixel openings 61; a pixel opening 61 exposes at least a portion of a first electrode 31.

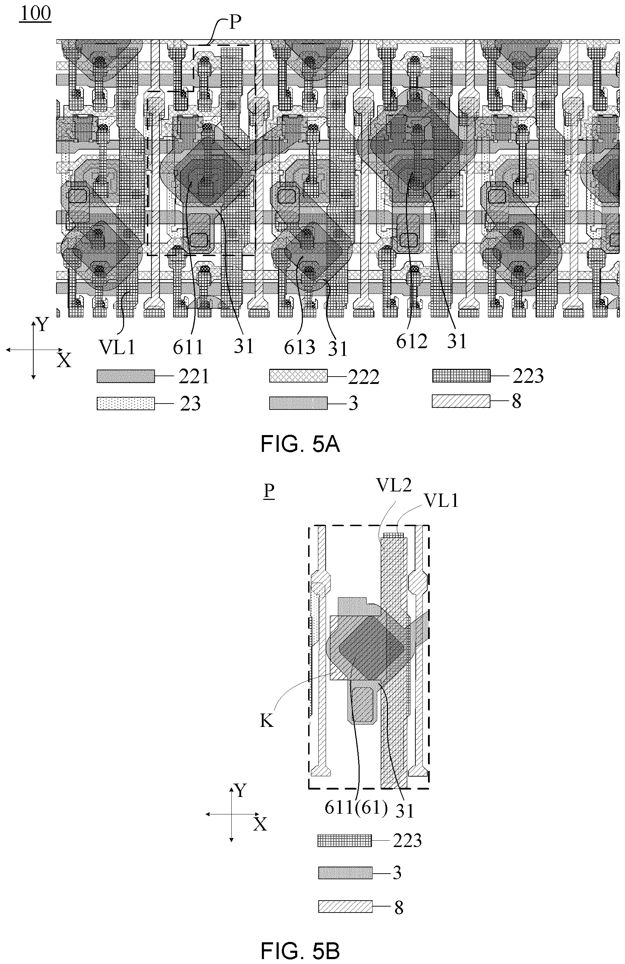

In some examples, referring to FIG. 5A, the plurality of pixel openings 61 include at least one first pixel opening 611, at least one second pixel opening 612 and at least one third pixel opening 613.

The first pixel opening 611 is configured to define an effective light-emitting region of first-color light, the second pixel opening 612 is configured to define an effective light-emitting region of second-color light, and the third pixel opening 613 is configured to define an effective light-emitting region of third-color light. The first-color light, the second-color light and the third-color light are three-primary-color light.

For example, referring to FIG. 5A, an area of the first pixel opening 611 is less than an area of the second pixel opening 612, and the area of the first pixel opening 611 is greater than an area of the third pixel opening 613.

For example, the first-color light is red light, the second-color light is blue light, and the third-color light is green light.

In some of the above examples, the first pixel opening 611, the second pixel opening 612 and the third pixel opening 613, which respectively transmit light of different colors, may constitute a pixel light-emitting region, so that the pixel light-emitting region is able to display light of a plurality of colors to achieve display of a plurality of grayscales (e.g., 256 grayscales). On this basis, by adjusting a magnitude relationship among the area of the first pixel opening 611, the area of the second pixel opening 612 and the area of the third pixel opening 613, it is possible to make the display panel 100 have a relatively high image display accuracy, a relatively good definition and a relatively good display effect.

In some examples, referring to FIG. 3, the display panel 100 further includes a plurality of supporting pads 10 located between the pixel definition layer 6 and the second electrode layer 4.

In some of the above examples, the plurality of supporting pads 10 are used to support a mask used when manufacturing the display panel 100 and structures formed above the plurality of supporting pads 10.

In some examples, referring to FIG. 3, the circuit structure layer 2 includes at least one metal layer 22, and part of the at least one metal layer 22 forms part of structures of the plurality of pixel driving circuits 21.

It will be noted that, a description that the part of the at least one metal layer 22 forms the part of structures of the plurality of pixel driving circuits 21 may mean that, for example, a partial structure of the at least one metal layer 22 serves as the part of structures of the plurality of pixel driving circuits 21.

For example, with continued reference to FIG. 3, the at least one metal layer 22 includes a first gate layer 221, a second gate layer 222 and a source-drain metal layer 223 that are sequentially away from the substrate 1.

For example, with continued reference to FIG. 3, the circuit structure layer 2 further includes an active layer 23, a first insulating layer 24, a second insulating layer 25 and an interlayer dielectric layer 26. The active layer 23 is located on a side of the first gate layer 221 proximate to the substrate 1, the first insulating layer 24 is located between the active layer 23 and the first gate layer 221, the second insulating layer 25 is located between the first gate layer 221 and the second gate layer 222, and the interlayer dielectric layer 26 is located between the second gate layer 222 and the source-drain metal layer 223.

In some examples, with continued reference to FIG. 4, in a sub-pixel region P, the pixel driving circuit includes a driving transistor DT and at least one switching transistor ST.

For example, the at least one switching transistor ST includes a data compensation transistor.

It will be noted that the type of the data compensation transistor varies, and may be, for example, an amorphous oxide semiconductor transistor.

Hereinafter, with reference to FIGS. 5A to 10, the structure of the display panel 100 is schematically described by taking an example where the structure of the pixel driving circuit 21 is the "7T1 C".

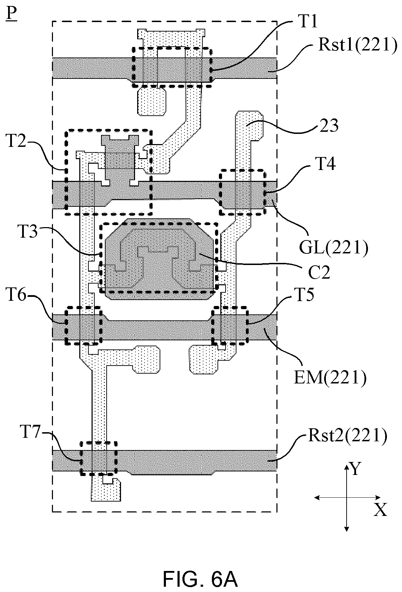

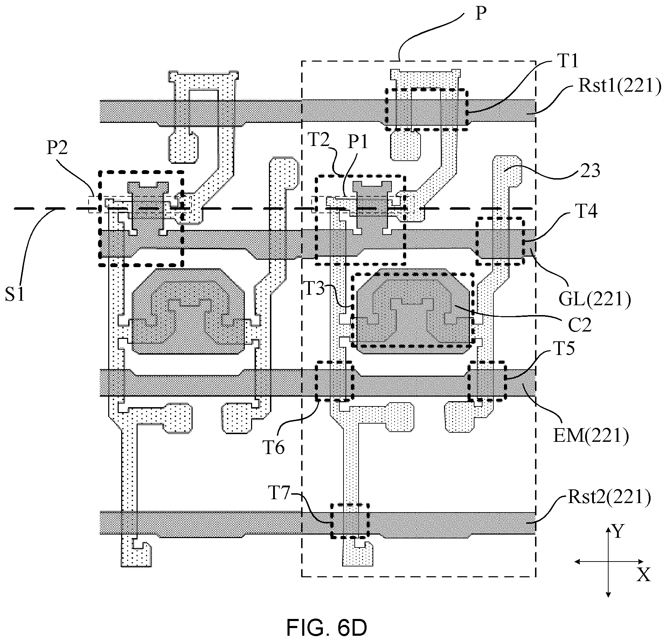

In some examples, referring to FIGS. 5A and 6A, FIG. 5A is a diagram showing the structure of yet another display panel 100 provided in some embodiments of the present disclosure, and FIG. 6A is a diagram showing a positional relationship of the active layer 23 and the first gate layer 221 in a sub-pixel region P in FIG. 5A. The pixel driving circuit 21 may include a driving transistor T3, a first light-emitting control transistor T6, a second light-emitting control transistor T5, a data writing transistor T4, a storage capacitor C, a data compensation transistor T2, a first reset transistor T7 and a second reset transistor T1. The data compensation transistor T2 may be, for example, a switching transistor ST.

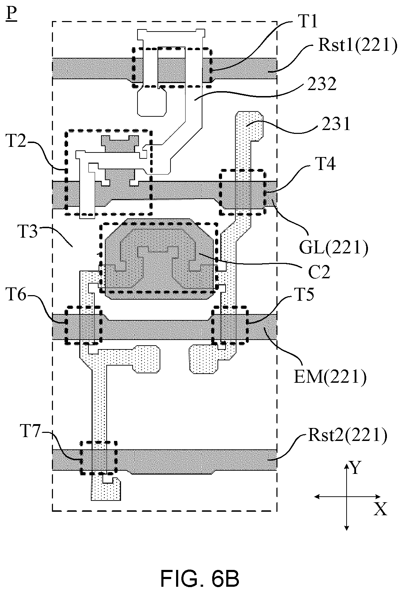

In some other examples, referring to FIG. 6B, FIG. 6B is a diagram showing another positional relationship of the active layers (231 and 232) and the first gate layer 221 in a sub-pixel region. In this case, the second reset transistor T1 and the data compensation transistor T2 are each a metal oxide transistor, the driving transistor T3, the data writing transistor T4, the second light-emitting control transistor T5, the first light-emitting control transistor T6 and the first reset transistor T7 are each a low temperature poly-silicon transistor. An active layer 231 of the low temperature poly-silicon transistor is located on a side of the first gate layer 221 proximate to the substrate. An active layer 232 of the metal oxide transistor is located on a side of the first gate layer 221 away from the substrate. For example, the active layer 232 of the metal oxide transistor may be located between the first gate layer 221 and the second gate layer 222. With this design, it is possible to effectively improve the anti-leakage performance of the second reset transistor T1 and the data compensation transistor T2, and it is conducive to reducing the production costs.

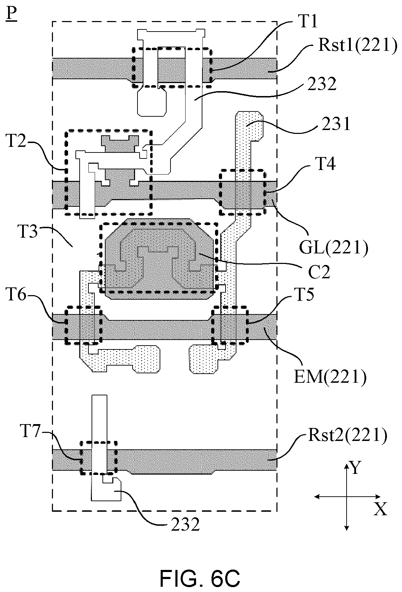

In yet other examples, referring to FIG. 6C, FIG. 6C is a diagram showing yet another positional relationship of the active layers (231 and 232) and the first gate layer 221 in a sub-pixel region. In these examples, the first reset transistor T7 is also a metal oxide transistor, which is different from FIG. 6B. With this design, it is conducive to improving the anti-leakage performance of the first reset transistor T7 and further reducing the manufacturing costs.

In some of the above embodiments, the driving transistor T3 may be, for example, of a single-gate structure, the first light-emitting control transistor T6 may be, for example, of a single-gate structure, the second light-emitting control transistor T5 may be, for example, of a single-gate structure, the data writing transistor T4 may be, for example, of a single-gate structure, the data compensation transistor T2 may be, for example, of a double-gate structure, the first reset transistor T7 may be, for example, of a single-gate structure, and the second reset transistor T1 may be, for example, of a double-gate structure.

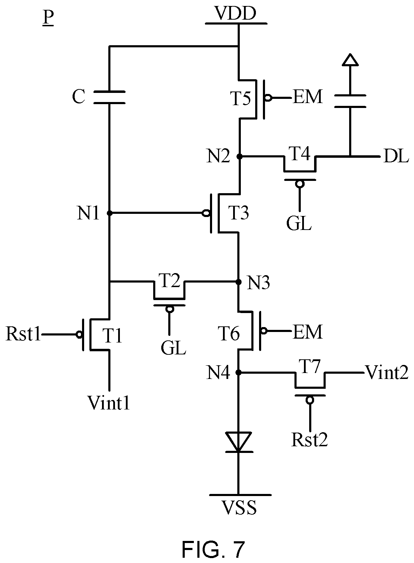

Referring to FIG. 7, and FIG. 7 is an equivalent circuit diagram of the sub-pixel region in FIG. 5A. The driving transistor DT is configured to provide a driving voltage for a light-emitting device electrically connected thereto to control a light-emitting state of the light-emitting device.

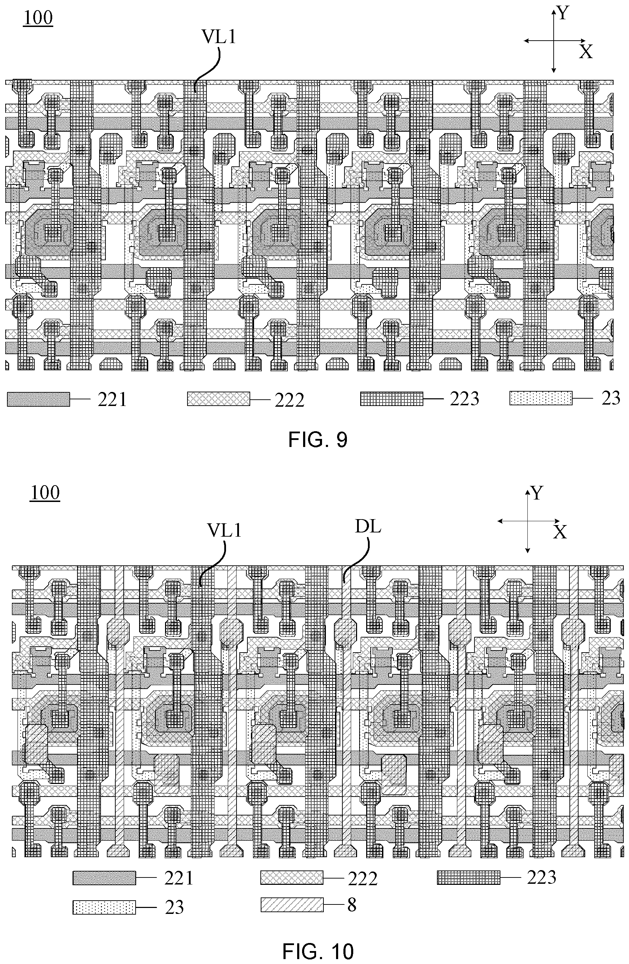

Referring to FIGS. 9 and 10, FIG. 9 is a diagram showing a positional relationship of the active layer 23, the first gate layer 221, the second gate layer 222 and the source-drain metal layer 223 in FIG. 5A, and FIG. 10 is a diagram showing a positional relationship of the active layer 23, the first gate layer 221, the second gate layer 222, the source-drain metal layer 223 and the conductive connection layer 8 in FIG. 5A.

In some examples, as shown in FIG. 5A, the display panel 100 further includes a plurality of data signal lines DL and a plurality of power supply signal lines. The plurality of data signal lines DL each extend in the second direction Y A power supply signal line may be electrically connected to a first voltage terminal VDD in FIG. 7 to provide a voltage signal. The power supply signal lines include first power supply signal lines VL1 located in the source-drain electrode layer 223 and each extending in the second direction Y

In some other examples, as shown in FIG. 5B, the power supply signal lines include a first power supply signal line VL1 located in the source-drain electrode layer 223 and extending in the second direction Y, and a second power supply signal line VL2 located in the conductive connection layer 8 and extending in the second direction Y In this case, the first power supply signal line VL1 is electrically connected to the second power supply signal line VL2, an orthographic projection of the first power supply signal line VL1 on the substrate 1 overlaps with an orthographic projection of the second power supply signal line VL2 on the substrate 1, and an orthogonal projection of at least one pixel opening 61 (e.g., the first pixel opening 611) on the substrate 1 is located within the orthographic projection of the second power supply signal line VL2 on the substrate 1. With this design, it is possible to reduce a light transmittance of film layers between the pixel opening 61 and the pixel driving circuit 21 to achieve a relatively good light blocking effect; in addition, it is also possible to planarize the first electrode 31 below the pixel opening 61 to improve a light-emitting uniformity.

For example, referring to FIG. 5B, the second power supply signal line VL2 has a plurality of protruding portions K, and an orthographic projection of a protruding portion K on the substrate 1 at least partially overlaps with an orthogonal projection, on the substrate 1, of a pixel opening 61 corresponding to a first electrode 31.

In this example, since the orthographic projection, on the substrate 1, of the protruding portion K of the second power supply signal line VL2 at least partially overlaps with the orthogonal projection, on the substrate 1, of the pixel opening 61 corresponding to the first electrode 31, it is possible to reduce the light transmittance of the film layers between the pixel opening 61 and the pixel driving circuit 21 to achieve the relatively good light blocking effect; furthermore, it is also possible to planarize the first electrode 31 below the pixel opening 61 to improve the light-emitting uniformity.

Referring to FIGS. 6A and 10, the display panel 100 further includes a gate line GL, a light-emitting control signal line EM, a first reset control signal line Rst1 and a second reset control signal line Rst2 that are located on a side of the power supply signal lines VL proximate to the substrate 1 and parallel to one another. Extending directions of the gate line GL, the light-emitting control signal line EM, the first reset control signal line Rst1 and the second reset control signal line Rst2 all intersect an extending direction of the data signal line DL. For example, the extending directions of the gate line GL, the light-emitting control signal line EM, the first reset control signal line Rst1 and the second reset control signal line Rst2 are all perpendicular to the extending direction of the data signal line DL.

In some examples, referring to FIG. 6A, parts of the first gate layer 221 serve as gates of the driving transistor T3, the first light-emitting control transistor T6, the second light-emitting control transistor T5, the data writing transistor T4, the data compensation transistor T2, the first reset transistor T7 and the second reset transistor T1, a second electrode C2 of the storage capacitor C that are in the pixel driving circuit 21, and the gate line GL, the light-emitting control signal line EM, the first reset control signal line Rst1 and the second reset control signal line Rst2 that are parallel to one another.

The display panel 100 further includes a plurality of reset signal lines located between a film layer where the gate line GL is located and a film layer where the data signal line DL is located, and the plurality of reset signal lines are configured to provide reset signals for the first electrodes 31 (i.e., the anodes of the light-emitting device) and/or the gates of the driving transistors T3.

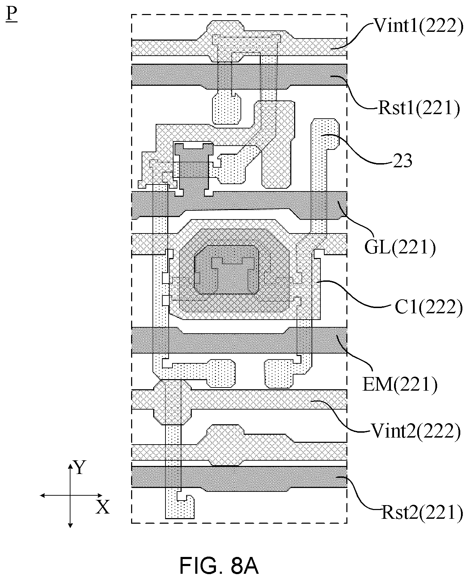

In some examples, referring to FIG. 8A, FIG. 8A is a diagram showing a positional relationship of the active layer 23, the first gate layer 221 and the second gate layer 222 in the sub-pixel region P in FIG. 5A. The plurality of reset signal lines include a first first reset signal line Vint1 and a second first reset power supply signals Vint2 both extending in the first direction X.

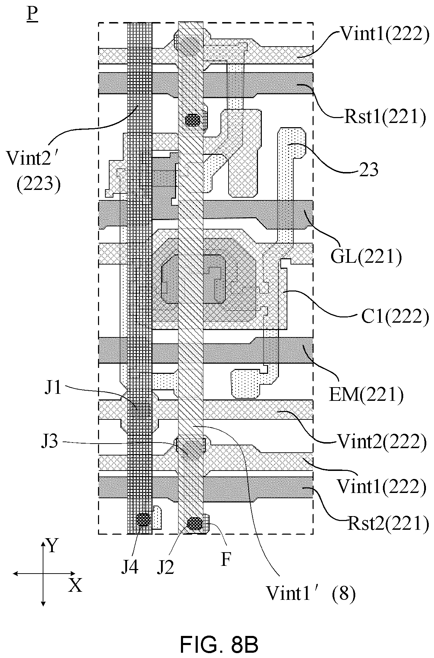

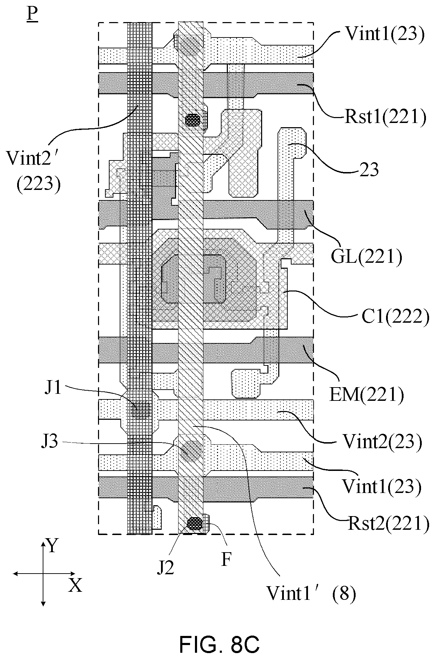

On this basis, referring to FIGS. 8B and 8C, and FIGS. 8B and 8C are each a diagram showing a positional relationship of the active layer 23, the first gate layer 221, the second gate layer 222, the source-drain metal layer 223 and the conductive connection layer 8 in a sub-pixel region P provided in some embodiments of the present disclosure. The plurality of reset signal lines may further include, for example, a first second reset signal line Vint1' and a second second reset signal line Vint2' both extending in the second direction Y The first first reset signal line Vint1 is electrically connected to the first second reset signal lines Vint1' to reset the gate of the driving transistor T3, and the second first reset signal line Vint2 is electrically connected to the second second reset signal line Vint2' to reset the first electrode 31 (i.e., the anode of the light-emitting device).

In some examples, referring to FIGS. 8A and 8B, parts of the second gate layer 222 serve as a first electrode C1 of the storage capacitor C in the pixel driving circuit 21, the first first reset signal lines Vint1 and the second first reset signal line Vint2.

On this basis, for example, referring to FIG. 8B, parts of the source-drain metal layer 223 serve as the first power supply signal line VL1 and the second second reset signal line Vint2' in the pixel driving circuit 21. In this case, an orthographic projection of the second first reset signal line Vint2 on the substrate 1 overlaps with an orthographic projection of the second second reset signal line Vint2' on the substrate 1, and the second first reset signal line Vint2 is electrically connected to the second second reset signal line Vint2' through a via hole J1 at the overlapping position. The second second reset signal line Vint2' is connected to the active layer 23 through a via hole J4.

In some other examples, as shown in FIG. 8C, a part of the second gate layer 222 serves as the first electrode C1 of the storage capacitor C in the pixel driving circuit 21. Parts of the active layer 23 serve as the first first reset signal lines Vint1 and the second first reset signal line Vint2. In this case, the part of the active layer 23 serves as the second first reset signal line Vint2, and the second second reset signal lines Vint2' is electrically connected to the second first reset signal line Vint2, thus the second second reset signal lines Vint2' does not need to be additionally connected to the active layer 23 through a via hole.

On the basis of some of the above examples, for example, as shown in FIGS. 8B and 8C, a part of the conductive connection layer 8 serves as the first second reset signal line Vint1' in the pixel driving circuit 21. In this case, the display panel 100 further includes a connection block F located in the source-drain electrode layer 223, the first second reset signal line Vint1' is electrically connected to the connection block F through a via hole J2, and the connection block F is electrically connected to the first first reset signal line Vint1 through a via hole J3, so that the first first reset signal line Vint1 is electrically connected to the first second reset signal lines Vint1'.

It will be noted that, in FIGS. 8B and 8C, the first second reset signal line Vint1' is illustrated as a straight line, and it will be understood that, in a practical product, in order to avoid interference with other structures disposed in a same layer, the first second reset signal line Vint1' may be provided with a bending avoidance portion therein. For example, in a case where the first second reset signal line Vint1' is located in the conductive connection layer 8, it is possible to avoid a transition block located in the conductive connection layer 8 and connected to the first electrode 31 by the bending avoidance portion. For another example, in a case where the first second reset signal line Vint1' is located in the source-drain electrode layer 223, it is possible to avoid a transition block located in the source-drain electrode layer 223 and connected to both of the data compensation transistor T2 and the driving transistor T3 by the bending avoidance portion. In addition, it will be understood that the present disclosure does not limit the number of bending avoidance portions. That is, the number of bending avoidance portions may be one or more, which may be set according to, for example, the number of structures that need to be avoided.

In some examples, referring to FIG. 10, and FIG. 10 is a diagram showing a positional relationship of the active layer 23, the first gate layer 221, the second gate layer 222, the source-drain metal layer 223 and the conductive connection layer 8 in FIG. 5A. Parts of the conductive connection layer 8 each serve as the data signal line DL in the pixel driving circuit 21. On this basis, referring to FIG. 5B, another part of the conductive connection layer 8 serves as the second power supply signal line VL2.

In some examples, referring to FIGS. 5A and 7, a first electrode of the data writing transistor T4 is configured to be electrically connected to the data signal line DL to receive a data signal, a second electrode of the data writing transistor T4 is configured to be electrically connected to a first electrode of the driving transistor T3 through a node N2, and a gate of the data writing transistor T4 is configured to be electrically connected to the gate line GL to receive a gate control signal. A first electrode of the data compensation transistor T2 is electrically connected to a second electrode of the driving transistor T3 through a node N3, a second electrode of the data compensation transistor T2 is electrically connected to the gate of the driving transistor T3 through a node N1, and a gate of the data compensation transistor T2 is configured to be electrically connected to the gate line GL to receive the gate control signal. The first electrode C1 of the storage capacitor C is electrically connected to the first voltage terminal VDD, and the second electrode C2 of the storage capacitor C is electrically connected to the gate of the driving transistor T3 through the node N1.

A first electrode of the first reset transistor T7 is configured to be electrically connected to the second first reset signal line Vint2 to receive a reset signal, a second electrode of the first reset transistor T7 is electrically connected to a first terminal of the light-emitting device through a node N4, and a gate of the first reset transistor T7 is configured to be electrically connected to the second reset control signal line Rst2 to receive a reset control signal. A first electrode of the second reset transistor T1 is configured to be electrically connected to the first first reset signal line Vint1 to receive a reset signal, a second electrode of the second reset transistor T1 is electrically connected to the gate of the driving transistor T3 through the node N1, and a gate of the second reset transistor T1 is configured to be electrically connected to the first reset control signal line Rst1 to receive a reset control signal.

A first electrode of the first light-emitting control transistor T6 is electrically connected to the second electrode of the driving transistor T3 through the node N3, a second electrode of the first light-emitting control transistor T6 is electrically connected to the first electrode of the light-emitting device through the node N4, and a gate of the first light-emitting control transistor T6 is configured to be electrically connected to the light-emitting control signal line EM to receive a light-emitting control signal. A first electrode of the second light-emitting control transistor T5 is electrically connected to the first voltage terminal VDD, a second electrode of the second light-emitting control transistor T5 is electrically connected to the first electrode of the driving transistor T3 through the node N2, and a gate of the second light-emitting control transistor T5 is configured to be electrically connected to the light-emitting control signal line EM to receive the light-emitting control signal. A second electrode of the light-emitting device is electrically connected to a second voltage terminal VSS.

In this case, the at least one switching transistor ST includes the first light-emitting control transistor T6, the second light-emitting control transistor T5, the data writing transistor T4, the data compensation transistor T2, the first reset transistor T7 and the second reset transistor T1.

It will be noted that, in the pixel driving circuit 21 provided in some of the above examples, the node N1, the node N2, the node N3 and the node N4 do not represent components that actually exist, but represent junction points of relevant electrical connections in a circuit diagram. That is, these nodes are nodes equivalent to the junction points of the relevant electrical connections in the circuit diagram.

In addition, according to properties of thin film transistors, the thin film transistors may be classified into N-type transistors and P-type transistors. The thin film transistors in the embodiments of the present disclosure are the P-type transistors, and the P-type transistors may be, for example, P-type Metal-Oxide-Semiconductor (MOS) transistors. That is, in the description of the embodiments of the present disclosure, the driving transistor T3, the first light-emitting control transistor T6, the second light-emitting control transistor T5, the data writing transistor T4, the data compensation transistor T2, the first reset transistor T7 and the second reset transistor T1 may be the P-type transistors. However, it will be easily understood that the thin film transistors in the embodiments of the present disclosure are not limited to the P-type transistors, those skilled in the art may use the N-type transistor(s) to realize the function of one or more thin film transistors in the embodiments of the present disclosure according to actual needs, and the N-type transistor(s) may be, for example, N-type MOS transistor(s).

It will be seen from FIGS. 5A to 10, since the area of the third pixel opening 613 is less than both of the area of the first pixel opening 611 and the area of the second pixel opening 612, and a pixel opening 61 needs to expose at least a portion of a first electrode 31, an area of a first electrode 31 corresponding to the third pixel opening 613 is also less than both of an area of a first electrode 31 corresponding to the first pixel opening 611 and an area of a first electrode corresponding to the second pixel opening 611. Therefore, in a sub-pixel region P corresponding to the third pixel opening 613, the first electrode 31 can not cover all of the switching transistors ST (including the data compensation transistor T2) in the pixel driving circuit 21. That is, when light is cast upon the display panel 100, in the sub-pixel region P corresponding to the third pixel opening 613, there is no film layer above the at least one switching transistor ST (including the data compensation transistor T2) to cover and protect the at least one switching transistor ST, which causes the light to affect the properties of the switching transistor ST (e.g., the data compensation transistor T2). As a result, problems such as a current leakage of the switching transistor ST (e.g., the data compensation transistor T2) are prone to occur, thereby affecting the display effect.

In light of this, some embodiments of the present disclosure provide a display panel 100. Referring to FIG. 5A, an orthogonal projection, on the substrate 1, of a pixel opening 61 corresponding to at least one first electrode 31 is spaced apart from an orthographic projection, on the substrate 1, of a gate of a data compensation transistor T2 in a pixel driving circuit 21 corresponding to the first electrode 31.

For example, referring to FIG. 5A, an orthogonal projection, on the substrate 1, of a first pixel opening 611 is spaced apart from an orthographic projection, on the substrate 1, of a gate of a data compensation transistor T2 in a pixel driving circuit 21 corresponding to the first pixel opening 611. On this basis, for example, referring to FIG. 5A, an orthogonal projection, on the substrate 1, of a third pixel opening 613 may also be spaced apart from an orthographic projection, on the substrate 1, of a gate of a data compensation transistor T2 in a pixel driving circuit 21 corresponding to the third pixel opening 613.

An orthographic projection of the at least one first electrode 31 on the substrate 1 at least partially overlaps with both of an orthographic projection, on the substrate 1, of a gate of a data compensation transistor T2 in a pixel driving circuit 21 corresponding to the first electrode 31 and an orthographic projection, on the substrate 1, of a gate of a data compensation transistor T2 in at least one pixel driving circuit 21 adjacent to the pixel driving circuit 21 corresponding to the first electrode 31. The data compensation transistor may be, for example, the amorphous oxide semiconductor transistor.

On this basis, for a first electrode 31 of the at least one first electrode 31, an orthographic projection, on the substrate 1, of a data compensation transistor T2 corresponding to the first electrode 31 and a first virtual straight line S1 extending in the first direction X have a first overlapping portion P1, an orthographic projection, on the substrate 1, of a data compensation transistor T2 in a pixel driving circuit 21 adjacent to the pixel driving circuit 21 corresponding to the first electrode 31 and the first virtual straight line S1 have a second overlapping portion P2, and a distance, in the first direction X, between the first overlapping portion P1 and the second overlapping portion P2 is greater than a dimension, in the first direction X, of a pixel opening 61 corresponding to the first overlapping portion P1.

In summary, in the display panel 100 provided in some embodiments of the present disclosure, the at least one first electrode 31 protects the gate of the data compensation transistor T2 in the pixel driving circuit 21 corresponding thereto and the gate of the data compensation transistor T2 in the at least one pixel driving circuit 21 adjacent to the pixel driving circuit 21 corresponding the first electrode 31, which may prevent the light cast upon the display panel 100 from affecting the properties of the data compensation transistor T2, thereby preventing the problems such as the current leakage of the data compensation transistor T2 from occurring, and improving the stability of the performance of the display panel 100.

On this basis, since the distance, in the first direction X, between the first overlapping portion P1 and the second overlapping portion P2 is greater than the dimension, in the first direction X, of the pixel opening 61 corresponding to the first overlapping portion P1, a distance between the data compensation transistor T2 corresponding to the first electrode 31 and the data compensation transistor T2 in the pixel driving circuit 21 adjacent to the pixel driving circuit 21 corresponding to the first electrode 31 is relatively large, which is conducive to preventing a problem of signal interference from occurring between the two data compensation transistors T2.

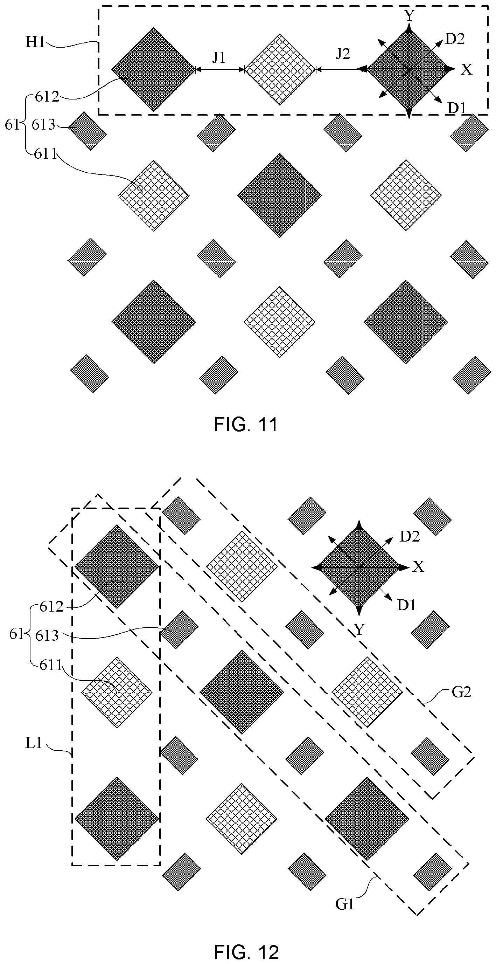

In some examples, referring to FIGS. 11 to 16, the plurality of pixel openings 61 are arranged in a plurality of rows and a plurality of columns, and two adjacent rows of pixel openings 61 are staggered from one another in the first direction X.

In the two adjacent rows of pixel openings 61, a row of pixel openings 61 include first pixel openings 611 and second pixel openings 612 that are alternately arranged in the first direction X, and another row of pixel openings 61 include third pixel openings 613 sequentially arranged in the first direction X.

In two adjacent columns of pixel openings 61, a column of pixel openings 61 include first pixel openings 611 and second pixel openings 612 that are alternately arranged in the second direction Y, and another column of pixel openings 61 include third pixel openings 613 sequentially arranged in the second direction Y

In some of the above examples, by limiting the arrangement manner of the first pixel openings 611, the second pixel openings 612 and the third pixel openings 613 that are all in the plurality of pixel openings 61, it is possible to have a weakening effect on jagged border of the display region of the display panel 100, thereby reducing an effect of the jagged border of the display panel 100. As a result, the display quality is significantly improved.

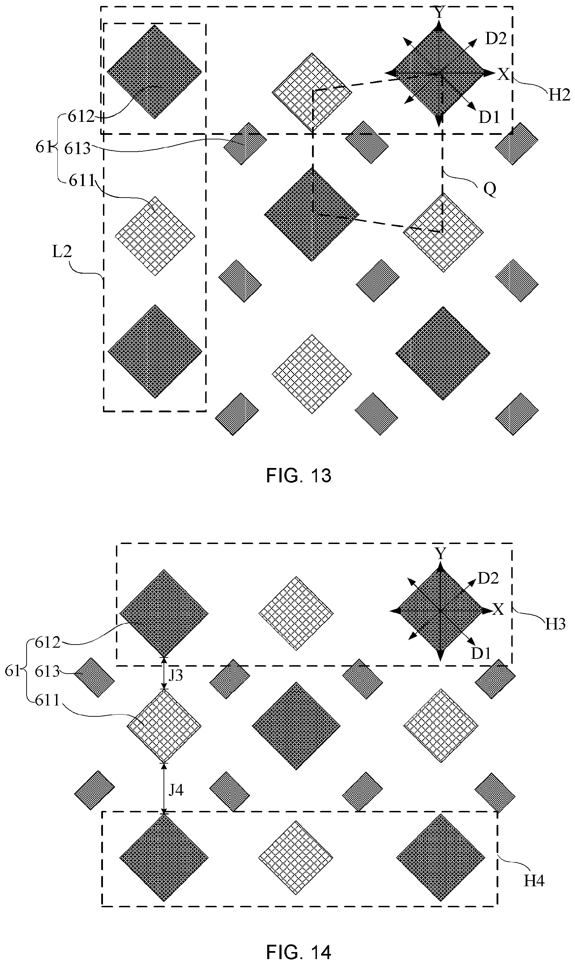

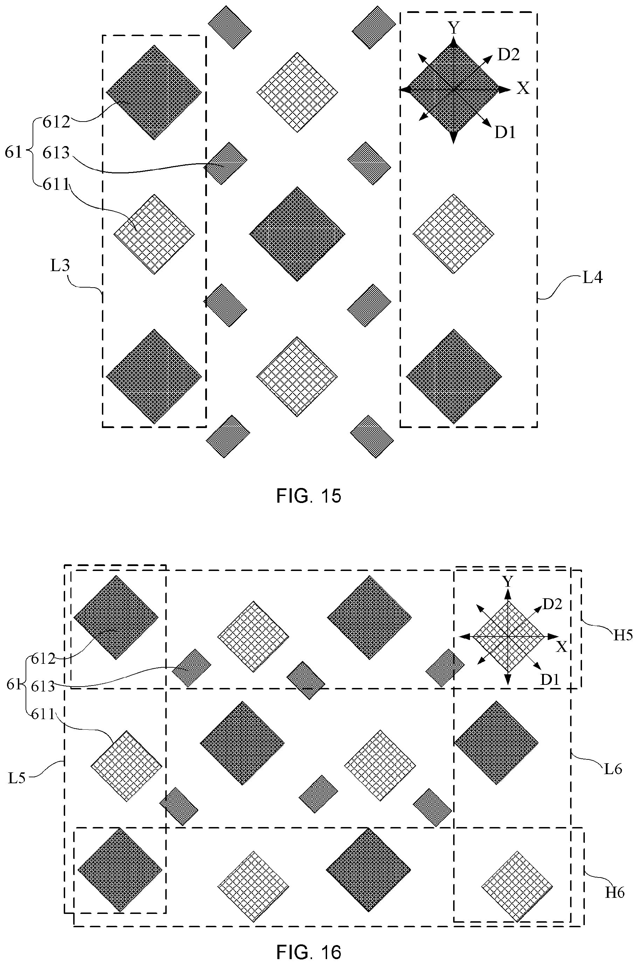

It will be noted that the first pixel openings 611 and the second pixel openings 612 that are in a same row are alternately arranged in the first direction X. In this case, there may be no distance, in the second direction Y, between a center of the first pixel opening 611 and a center of the second pixel opening 612 as shown, for example, in FIGS. 11, 12, 14 and 15 (that is, in the first pixel openings 611 and the second pixel openings 612 that are in the same row, the centers of the first pixel openings 611 and the centers of the second pixel openings 612 are located on a same straight line extending in the first direction X); alternatively, there may be a certain distance, in the second direction Y, between the center of the first pixel opening 611 and the center of the second pixel opening 612 as shown, for example, in FIGS. 13 and 16 (that is, in the first pixel openings 611 and the second pixel openings 612 that are in the same row, the centers of the first pixel openings 611 and the centers of the second pixel openings 612 are not located on a same straight line extending in the first direction X).

Similarly, the first pixel openings 611 and the second pixel openings 612 that are in a same column are alternately arranged in the second direction Y In this case, there may be no distance, in the first direction X, between the center of the first pixel opening 611 and the center of the second pixel opening 612 as shown, for example, in FIGS. 11, 12, 13, 14 and 15 (that is, in the first pixel openings 611 and the second pixel openings 612 that are in the same column, the centers of the first pixel openings 611 and the centers of the second pixel openings 612 are located on a same straight line extending in the second direction Y); alternatively, there may be a certain distance, in the first direction X, between the center of the first pixel opening 611 and the center of the second pixel opening 612 as shown, for example, in FIG. 16 (that is, in the first pixel openings 611 and the second pixel openings 612 that are in the same row, the centers of the first pixel openings 611 and the centers of the second pixel openings 612 are not located on a same straight line extending in the second direction Y).

The center of the first pixel opening 611 may be, for example, a geometric center of the first pixel opening 611. Similarly, the center of the second pixel opening 612 may be, for example, a geometric center of the second pixel opening 612.

For example, referring to FIG. 11, in any row of pixel openings 61 including first pixel openings 611 and second pixel openings 612 that are alternately arranged, any first pixel opening 611 has an equal distance (i.e., J1 and J2 in FIG. 11) to two second pixel openings 612 adjacent to the any first pixel opening 11.

With this design, the first pixel opening 611, the second pixel opening 612 and the third pixel opening 613, which respectively transmit the light of different colors, may constitute the pixel light-emitting region, so that the pixel light-emitting region is able to display the light of the plurality of colors to achieve the display of the plurality of gray scales (e.g., the 256 gray scales). On this basis, by adjusting the distance between the first pixel opening 611 and the second pixel opening 612, it is possible to improve the image display accuracy, the definition and the display effect of the display panel 100.

For example, referring to FIG. 14, in any column of pixel openings 61 including first pixel openings 611 and second pixel openings 612 that are alternately arranged, any first pixel opening 611 has distances (i.e., J3 and J4 in FIG. 14), that are not equal, to two second pixel openings 612 adjacent to the any first pixel opening 611, respectively.

With this design, the first pixel opening 611, the second pixel opening 612 and the third pixel opening 613, which respectively transmit the light of different colors, may constitute the pixel light-emitting region, so that the pixel light-emitting region is able to display the light of the plurality of colors to achieve the display of the plurality of gray scales (e.g., the 256 gray scales). On this basis, by further adjusting the distance between the first pixel opening 611 and the second pixel opening 612, it is possible to further improve the image display accuracy, the definition and the display effect of the display panel 100.

For example, referring to FIG. 14, geometrical centers of a first pixel opening 611 and a second pixel opening 612 that are adjacent to each other in a column of pixel openings 61, and geometrical centers of a first pixel opening 611 and a second pixel opening 612 that are adjacent to each other in an adjacent column of pixel openings 61 are sequentially connected to form a virtual trapezoid Q.

With this design, the first pixel opening 611, the second pixel opening 612 and the third pixel opening 613, which respectively transmit the light of different colors, may constitute the pixel light-emitting region, so that the pixel light-emitting region is able to display the light of the plurality of colors to achieve the display of the plurality of gray scales (e.g., the 256 gray scales). On this basis, by limiting a positional relationship of the first pixel openings 611 and the second pixel openings 612 in two adjacent columns of pixel openings 61, it is possible to further improve the image display accuracy, the definition and the display effect of the display panel 100.

For example, in the same row of pixel openings 61, the center of the first pixel opening 611 and the center of the second pixel opening 612 have a distance in the second direction Y therebetween. With this design, it is possible to better match the light of various colors in the pixel light-emitting region, so that the display panel 100 has a higher image display accuracy, a better definition and a better display effect. The distance may be, for example, less than or equal to half of a dimension of the first pixel opening 611 in the second direction Y With this design, it is possible to further have the weakening effect on the jagged border of the display region of the display panel 100 in a case where the image display accuracy and the definition of the display panel 100 is ensured, thereby better reducing the effect of the jagged border of the display panel 100 and improving the display quality of the display panel 100.

For example, in the same column of pixel openings 61, the center of the first pixel opening 611 and the center of the second pixel opening 612 have a distance in the first direction X therebetween. With this design, it is possible to better match the light of various colors in the pixel light-emitting region, so that the display panel 100 has the higher image display accuracy, the better definition and the better display effect. The distance may be, for example, less than or equal to half of a dimension of the first pixel opening 611 in the first direction X. With this design, it is possible to further have the weakening effect on the jagged border of the display region of the display panel 100 in the case where the image display accuracy and the definition of the display panel 100 is ensured, thereby better reducing the effect of the jagged border of the display panel 100 and improving the display quality of the display panel 100.

In some examples, referring to FIGS. 11 to 16, pixel openings 61 closest to a border of the display region A includes at least one row of pixel openings 61 including first pixel openings 611 and second pixel openings 612 that are alternately arranged in the first direction X, and/or at least one column of pixel openings 61 including first pixel openings 611 and second pixel openings 612 that are alternately arranged in the second direction Y With this design, the pixel openings 61 closest to the border of the display region A include more first pixel openings 611 and more second pixel openings 612. In this case, since the area of the first pixel opening 611 and the area of the second pixel opening 612 are both greater than the area of the third pixel opening 613, it is possible to reduce gaps among the pixel openings 61 closest to the border of the display region A as much as possible, which may further have the weakening effect on the jagged border of the display region of the display panel 100, thereby better reducing the effect of the jagged border of the display panel 100 and further improving the display quality of the display panel 100.

In a case where the display region A is in a shape of a rectangle, the pixel openings 61 closest to the border of the display region A may be, for example, two rows of pixel openings 61 closest to the border of the display region A and two column of pixel openings 61 closest to the border of the display region A.

For example, referring to FIG. 11, the pixel openings 61 closest to the border of the display region A include only one row of pixel openings 61 including first pixel openings 611 and second pixel openings 612 that are alternately arranged in the first direction X (as shown in the dotted box H1).

For another example, referring to FIG. 12, the pixel openings 61 closest to the border of the display region A include only one column of pixel openings 61 including first pixel openings 611 and second pixel openings 612 that are alternately arranged in the second direction Y (as shown in the dotted box L1).

For yet another example, referring to FIG. 13, the pixel openings 61 closest to the border of the display region A include only one row of pixel openings 61 including first pixel openings 611 and second pixel openings 612 that are alternately arranged in the first direction X (as shown in the dotted box H2) and one column of pixel openings 61 including first pixel openings 611 and second pixel openings 612 that are alternately arranged in the second direction Y (as shown in the dotted box L2).

For yet another example, referring to FIG. 14, the pixel openings 61 closest to the border of the display region A include two rows of pixel openings 61 including first pixel openings 611 and second pixel openings 612 that are alternately arranged in the first direction X (as shown in the dotted box H3 and the dotted box H4).

For yet another example, referring to FIG. 15, the pixel openings 61 closest to the border of the display region A include two columns of pixel openings 61 including first pixel openings 611 and second pixel openings 612 that are alternately arranged in the second direction Y (as shown in the dotted box L3 and the dotted box L4).

For yet another example, referring to FIG. 16, the pixel openings 61 closest to the border of the display region A include two rows of pixel openings 61 including first pixel openings 611 and second pixel openings 612 that are alternately arranged in the first direction X (as shown in the dotted box H5 and the dotted box H6) and two columns of pixel openings 61 including first pixel openings 611 and second pixel openings 612 that are alternately arranged in the second direction Y (as shown in the dotted box L5 and the dotted box L6).

In some examples, a ratio among the area of the first pixel opening 611, the area of the second pixel opening 612 and the area of the third pixel opening 613 is (2.09-2.10):(3.69-3.70):(1.41-1.42).

In some of the above examples, by limiting the ratio among the area of the first pixel opening 611, the area of the second pixel opening 612 and the area of the third pixel opening 613, it is possible to further have the weakening effect on the jagged border of the display region of the display panel 100, thereby better reducing the effect of the jagged border of the display panel 100 and further improving the display quality of the display panel 100.

For example, a shape of the first pixel opening 611 is substantially any one of a square, a rectangle, a rhombus, a circle, an ellipse, an olive, a hexagon and an octagon. The shape of the first pixel opening 611 may be, for example, the square. With this design, it is possible to make the shape of the first pixel opening 611 more regular, so that the first pixel openings 611, the second pixel openings 612 and the third pixel openings 613 are arranged more regularly. Therefore, it is possible to better match the light of various colors in the pixel light-emitting region, so that the display panel 100 has the higher image display accuracy, the better definition and the better display effect.

For example, a shape of the second pixel opening 612 is substantially any one of a square, a rectangle, a rhombus, a circle, an ellipse, an olive, a hexagon and an octagon. The shape of the second pixel opening 612 may be, for example, the square. With this design, it is possible to make the shape of the second pixel opening 612 more regular, so that the second pixel openings 612, the first pixel openings 611 and the third pixel openings 613 are arranged more regularly. Therefore, it is possible to better match the light of various colors in the pixel light-emitting region, so that the display panel 100 has the higher image display accuracy, the better definition and the better display effect.

For example, a shape of the third pixel opening 613 is substantially any one of a square, a rectangle, a rhombus, a circle, an ellipse, an olive, a hexagon and an octagon. The shape of the third pixel opening 613 may be, for example, the square. With this design, it is possible to make the shape of the third pixel opening 613 more regular, so that the third pixel openings 613, the first pixel openings 611 and the second pixel openings 612 are arranged more regularly. Therefore, it is possible to better match the light of various colors in the pixel light-emitting region, so that the display panel 100 has the higher image display accuracy, the better definition and the better display effect.

In some examples, referring to FIGS. 11 to 16, the shape of each of the first pixel opening 611, the second pixel opening 612 and the third pixel opening 613 is substantially a rectangle.

On this basis, for example, a size of the first pixel opening 611 is 14.48 µm × 14.48 µm; a size of the second pixel opening 612 is 19.23 µm × 19.23 µm; a size of the third pixel opening 613 is 12.63 µm × 11.21 µm. With this design, the first pixel openings 611, the second pixel openings 612 and the third pixel openings 613 may be arranged more regularly, and thus it is possible to better match the light of various colors in the pixel light-emitting region, thereby enabling the display panel 100 to have the higher image display accuracy, the better definition and the better display effect. Moreover, it is possible to further have the weakening effect on the jagged border of the display region of the display panel 100, thereby better reducing the effect of the jagged border of the display panel 100 and further improving the display quality of the display panel 100.

Therefore, in some of the above examples, by limiting the arrangement manner of the first pixel openings 611, the second pixel openings 612 and the third pixel openings 613 that are all in the plurality of pixel openings 61, the colors of light corresponding to the effective light-emitting regions respectively defined by the first pixel opening 611, the second pixel opening 612 and the third pixel opening 613, and the areas of the first pixel opening 611, the second pixel opening 612 and the third pixel opening 613, it is possible to better match the light of various colors in the pixel light-emitting region, and it is also possible to further have the weakening effect on the jagged border of the display region of the display panel 100 to reduce the effect of the jagged border of the display panel 100. As a result, the image display accuracy is higher, the definition is better, and the display effect is better, thereby improving the display quality.

In some embodiments, referring to FIG. 5A, an orthographic projection, on the substrate 1, of a first electrode 31 corresponding to the first pixel opening 611 at least partially overlaps with both of an orthographic projection, on the substrate 1, of a gate of a data compensation transistor T2 in a pixel driving circuit 21 corresponding to the first electrode 31, and an orthographic projection, on the substrate 1, of a gate of a data compensation transistor T2 in at least one pixel driving circuit 21 adjacent to the pixel driving circuit 21 corresponding to the first electrode 31.

In some of the above embodiments, the first electrode 31 corresponding to the first pixel opening 611 protects the gate of the data compensation transistor T2 in the pixel driving circuit 21 corresponding thereto and the gate of the data compensation transistor T2 in the at least one pixel driving circuit 21 adjacent to the pixel driving circuit 21 corresponding to the first electrode 31, which may prevent the light cast upon the display panel 100 from affecting the properties of the data compensation transistor T2, thereby preventing the problems such as the current leakage of the data compensation transistor T2 from occurring, and finally improving the stability of the performance of the display panel 100.

In some embodiments, referring to FIG. 5A, an orthographic projection, on the substrate 1, of a first electrode 31 corresponding to the second pixel opening 612 at least partially overlaps with both of an orthographic projection, on the substrate 1, of a gate of a data compensation transistor T2 in a pixel driving circuit 21 corresponding to the first electrode 31, and an orthographic projection, on the substrate 1, of a gate of a data compensation transistor T2 in at least one pixel driving circuit 21 adjacent to the pixel driving circuit 21 corresponding to the first electrode 31.

In some of the above embodiments, the first electrode 31 corresponding to the second pixel opening 612 protects the gate of the data compensation transistor T2 in the pixel driving circuit 21 corresponding thereto and the gate of the data compensation transistor T2 in the at least one pixel driving circuit 21 adjacent to the pixel driving circuit 21 corresponding to the first electrode 31, which may prevent the light cast upon the display panel 100 from affecting the properties of the data compensation transistor T2, thereby preventing the problems such as the current leakage of the data compensation transistor T2 from occurring, and finally improving the stability of the performance of the display panel 100.

In some embodiments, referring to FIGS. 5A and 11 to 16, first pixel openings 611 and third pixel openings 613 are alternately arranged in a third direction D1 to constitute first groups of pixel openings G1 (as shown in FIG. 12), second pixel openings 612 and third pixel openings 613 are alternately arranged in the third direction D1 to constitute second groups of pixel openings G2 (as shown in FIG. 12), and the first groups of pixel openings G1 and the second groups of pixel openings G2 are alternately arranged in a fourth direction D2; the third direction D1 intersects the fourth direction D2.

Referring to FIG. 5A, in a first group of pixel openings G1, an orthographic projection, on the substrate 1, of a first electrode 31 corresponding to a first pixel opening 611 at least partially overlaps with an orthographic projection, on the substrate 1, of a gate of a data compensation transistor T2 in a pixel driving circuit 21 corresponding to a third pixel opening 613 adjacent to the first pixel opening 611. With continued reference to FIG. 5A, in a second group of pixel openings G2, an orthographic projection, on the substrate 1, of a first electrode 31 corresponding to a second pixel opening 612 at least partially overlaps with an orthographic projection, on the substrate 1, of a gate of a data compensation transistor T2 in a pixel driving circuit 21 corresponding to a third pixel opening 613 adjacent to the second pixel opening 612.

It will be noted that the first pixel openings 611 and the third pixel openings 613 in the first group of pixel openings G1 are alternately arranged in the third direction D1. In this case, in the first group of pixel openings G1, there may be no distance between the center of the first pixel opening 611 and the center of the third pixel opening 613 in the fourth direction D2 as shown, for example, in FIGS. 11, 12, 14 and 15 (that is, the centers of the first pixel openings 611 and the centers of the third pixel openings 613 are located on a same straight line extending in the third direction D1); alternatively, there may be a certain distance between the center of the first pixel opening 611 and the center of the third pixel opening 613 in the fourth direction D2 as shown, for example, in FIGS. 13 and 16 (that is, the centers of the first pixel openings 611 and the centers of the third pixel openings 613 are located on different straight lines each extending in the fourth direction D2, respectively), and the distance may be, for example, less than or equal to half of a dimension of the third pixel opening 613 in the fourth direction D2.

Similarly, in the second group of pixel openings G1, there may be no distance between the center of the first pixel opening 611 and the center of the second pixel opening 612 in the fourth direction D2 as shown, for example, in FIGS. 11, 12, 14 and 15 (that is, the centers of the first pixel openings 611 and the centers of the second pixel openings 612 are located on a same straight line extending in the third direction D1); alternatively, there may be a certain distance between the center of the third pixel opening 613 and the center of the second pixel opening 612 in the fourth direction D2 as shown, for example, in FIGS. 13 and 16 (that is, the centers of the first pixel openings 611 and the centers of the second pixel openings 612 are located on different straight lines each extending in the fourth direction D2, respectively), and the distance may be, for example, less than or equal to half of the dimension of the third pixel opening 613 in the fourth direction D2.

The center of the third pixel opening 613 may be, for example, a geometric center of the third pixel opening 613.

In addition, a direction in which the first pixel openings 611 and the third pixel openings 613 are alternately arranged is defined with the third direction D1. In a case where the direction in which the first pixel openings 611 and the third pixel openings 613 are alternately arranged is changed, the third direction D1 is changed with the change of the direction in which the first pixel openings 611 and the third pixel openings 613 are alternately arranged. Similarly, the fourth direction D2 is also changed with the change of the direction in which the first pixel openings 611 and the third pixel openings 613 are alternately arranged.

For example, referring to FIGS. 11 to 16, the third direction D1 is perpendicular to the fourth direction D2, an angle between the third direction D1 and each of the first direction X and the second direction Y is approximately 45 degrees, and an angle between the second direction and each of the first direction X and the second direction Y is also approximately 45 degrees.

In some examples, referring to FIG. 5A, orthographic projections, on the substrate 1, of two first electrodes 31 respectively corresponding to a first pixel opening 611 and a second pixel opening 612 that are adjacent to each other at least partially overlap with orthographic projections, on the substrate 1, of gates of data compensation transistors T2 respectively corresponding to two third pixel openings 613 that are located on a same side of the first pixel opening 611 and the second pixel opening 612 that are adjacent to each other, respectively. With this design, it is possible to reduce the manufacturing difficulty of the first electrode 31 corresponding to the first pixel opening 611 and the first electrode 31 corresponding to the second pixel opening 612, so as to simplify the manufacturing process of the display panel 100.

In some of the above embodiments, the data compensation transistor T2 may be, for example, the amorphous oxide semiconductor transistor. The orthographic projection, on the substrate 1, of the first electrode 31 corresponding to the first pixel opening 611 and the orthographic projection, on the substrate 1, of the first electrode 31 corresponding to the second pixel opening 612 each at least partially overlap with an orthographic projection, on the substrate 1, of a gate of a data compensation transistor T2 in a pixel driving circuit 21 corresponding to a respective third pixel opening 613. That is, the first electrode 31 corresponding to the first pixel opening 611 and the first electrode 31 corresponding to the second pixel opening 612 each cover at least a portion of a gate of a data compensation transistor T2 in a pixel driving circuit 21 corresponding to a respective third pixel opening 613, which may protect the gate of the data compensation transistor T2 to prevent the light cast upon the display panel 100 from affecting a threshold compensation voltage of the data compensation transistor T2, thereby further improving the stability of the performance of the display panel 100.

For example, with continued reference to FIGS. 5A and 6A, the first electrode corresponding to the first pixel opening 611 further covers a node N1 corresponding to the first pixel opening 611; and/or the first electrode 31 corresponding to the second pixel opening 612 further covers a node N1 corresponding to the second pixel opening 612.

In some of the above examples, the first electrode 31 corresponding to the first pixel opening 611 or the first electrode 31 corresponding to the second pixel opening 612 covers the node N1 in the pixel driving circuit 21 corresponding thereto, so that the stability of the performance of the display panel 100 is further improved.

It is worth noting that the arrangement manner of the pixel openings 61 in some of the above examples are merely used for schematic descriptions, and the arrangement manner of the pixel openings 61 in the present disclosure are not limited to the above examples. For any arrangement manner capable of making at least one switching transistor ST in the pixel driving circuit 21 corresponding to the third pixel opening 613 have no film layer thereon for covering and protecting, by using the method, provided in some of the above examples, of covering the at least one switching transistor ST in the pixel driving circuit 21 corresponding to the third pixel opening 613 with the first electrode 31 corresponding to the first pixel opening 611 or the first electrode 31 corresponding to the second pixel opening 612, it may be possible to achieve the effect of preventing the light from affecting the properties of the switching transistor ST and further improving the stability of the performance of the display panel 100.

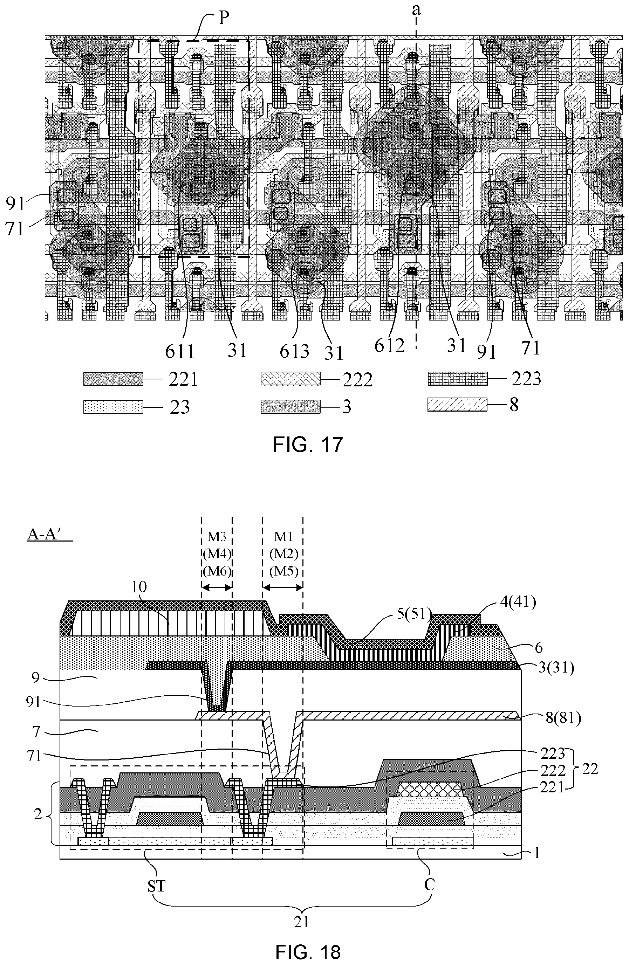

In some embodiments, referring to FIGS. 5A and 17, the plurality of data signal lines DL are located in the conductive connection layer 8 between the circuit structure layer 2 and the first electrode layer 3.

The first pixel opening 611, the second pixel opening 612 and the third pixel opening 613 are configured to be arranged according to at least one of a first manner, a second manner and a third manner.

In the first manner, an orthogonal projection of a border of the first pixel opening 611 on the substrate 1 is located between orthographic projections of two adjacent data signal lines DL on the substrate 1.

With regard to this, the plurality of data signal lines DL are manufactured on the side of the first electrode layer 3 proximate to the substrate 1, and the orthogonal projection of the border of the first pixel opening 611 on the substrate 1 is located between the orthographic projections of the two adjacent data signal lines DL on the substrate 1. In this case, the plurality of data signal lines DL are prevented from being manufactured directly below the first pixel openings 611, so that a portion of the first electrode layer 3 exposed by the first pixel opening 611 is prevented from being in a shape of steps. In this way, it is possible to ensure the planarization of the portion of the first electrode layer 3 exposed by the first pixel opening 611. On this basis, when the light-emitting functional layer 4 is manufactured on the portion of the first electrode layer 3 exposed by the first pixel opening 611, it is also possible to ensure the planarization of the light-emitting functional layer 4 at the portion, thereby ensuring the uniformity of the first-color light when the display panel 100 displays images.

In the second manner, an orthogonal projection of a border of the second pixel opening 612 on the substrate 1 is located between an orthographic projections of another two adjacent data signal lines DL on the substrate 1; alternatively, the orthographic projections of the another two adjacent data signal lines DL on the substrate 1 each partially overlap with the orthogonal projection of the border of the second pixel opening 612 on the substrate 1, and an area of an overlapping portion of the orthographic projection of one of the another two adjacent data signal lines DL on the substrate 1 and the orthogonal projection of the border of the second pixel opening 612 on the substrate 1 is approximately equal to an area of an overlapping portion of the orthographic projection of the other of the another two adjacent data signal lines DL on the substrate 1 and the orthogonal projection of the border of the second pixel opening 612 on the substrate 1.

With regard to this, the plurality of data signal lines DL are manufactured on the side of the first electrode layer 3 proximate to the substrate 1, and the orthogonal projection of the border of the second pixel opening 612 on the substrate 1 is located between the orthographic projections of the two adjacent data signal lines DL on the substrate 1. That is, the plurality of data signal lines DL are prevented from being manufactured directly below the second pixel openings 612, so that a portion of the first electrode layer 3 exposed by the second pixel opening 612 is prevented from being in a shape of steps. In this way, it is possible to ensure the planarization of the portion of the first electrode layer 3 exposed by the second pixel opening 612. On this basis, when the light-emitting functional layer 4 is manufactured on the portion of the first electrode layer 3 exposed by the second pixel opening 612, it is also possible to ensure the planarization of the light-emitting functional layer 4 at the portion, thereby ensuring the uniformity of the second-color light when the display panel 100 displays images.

In addition, the area of the second pixel opening 612 may be, for example, greater than the area of the first pixel opening 611 and the area of the third pixel opening 613, and in this case, since the area of the second pixel opening 612 is relatively large and a distance between the two adjacent data signal lines DL is relatively small, the orthogonal projection of the border of the second pixel opening 612 on the substrate 1 may partially overlap with both the orthographic projections of the two adjacent data signal lines DL on the substrate 1. On this basis, by controlling the area of the overlapping portion of the orthographic projection of one of the two adjacent data signal lines DL on the substrate 1 and the orthogonal projection of the border of the second pixel opening 612 on the substrate 1 to be approximately equal to the area of the overlapping portion of the orthographic projection of the other of the two adjacent data signal lines DL on the substrate 1 and the orthogonal projection of the border of the second pixel opening 612 on the substrate 1, it is possible to avoid the color cast in the effective light-emitting region defined with the second pixel opening 612, thereby ensuring the display quality of the display panel 100.

In the third manner, an orthogonal projection of a border of the third pixel opening 613 on the substrate 1 is located between orthographic projections of two adjacent data signal lines DL on the substrate 1.

With regard to this, the plurality of data signal lines DL are manufactured on the side of the first electrode layer 3 proximate to the substrate 1, and the orthogonal projection of the border of the third pixel opening 613 on the substrate 1 is located between the orthographic projections of the two adjacent data signal lines DL on the substrate 1. That is, the plurality of data signal lines DL are prevented from being manufactured directly below the third pixel openings 613, so that a portion of the first electrode layer 3 exposed by the third pixel opening 613 is prevented from being in a shape of steps. In this way, it is possible to ensure the planarization of the portion of the first electrode layer 3 exposed by the third pixel opening 613. On this basis, when the light-emitting functional layer 4 is manufactured on the portion of the first electrode layer 3 exposed by the third pixel opening 613, it is also possible to ensure the planarization of the light-emitting functional layer 4 at the portion, thereby ensuring the uniformity of the third-color light when the display panel 100 displays images.

It will be noted that, the description that the first pixel opening 611, the second pixel opening 612 and the third pixel opening 613 are configured to be arranged according to at least one of the first manner, the second manner and the third manner may be, for example, being arranged according to only one manner or being arranged according to a combination of two or three manners, which may be set according to actual needs.

For example, with continued reference to FIG. 17, the overlapping portion of the orthographic projection of one of the two adjacent data signal lines DL on the substrate 1 and the orthogonal projection of the border of the second pixel opening 612 on the substrate 1, and the overlapping portion of the orthographic projection of the other of the two adjacent data signal lines DL on the substrate 1 and the orthogonal projection of the border of the second pixel opening 612 on the substrate 1 are mirror-symmetric. With this design, it is possible to further ensure the consistency of the two overlapping portions to avoid the color cast in the effective light-emitting region defined with the second pixel opening 612, thereby further ensuring the display quality of the display panel 100.

For example, with continued reference to FIG. 17, another plane of symmetry (an orthogonal projection of the another plane of symmetry on the substrate 1 is the straight line a) of another two adjacent data signal lines DL is taken as another plane of symmetry, and the first pixel opening 611 is mirror-symmetric. With this design, it is possible to improve the uniformity of the arrangement of the first pixel openings 611 and the data signal lines DL, thereby further ensuring the display quality of the display panel 100.

For example, with continued reference to FIG. 13, the plane of symmetry (the orthogonal projection of the plane of symmetry on the substrate 1 is the straight line a) of the two adjacent data signal lines DL is taken as the plane of symmetry, the second pixel opening 612 is mirror-symmetric. With this design, it is possible to improve the uniformity of the arrangement of the second pixel openings 612 and the data signal lines DL. In addition, in a case where the orthographic projections of the two adjacent data signal lines DL on the substrate 1 each overlap with the orthogonal projection of the border of the second pixel opening 612 on the substrate 1, it is possible to reduce the manufacturing difficulty of the second pixel openings 612 on the premise of avoiding the color casts in the effective light-emitting regions defined with the second pixel openings 612, thereby simplifying the manufacturing process of the display panel 100 on the premise of further ensuring the display quality of the display panel 100.

For example, with continued reference to FIG. 17, a plane of symmetry (an orthogonal projection of the plane of symmetry on the substrate 1 is the straight line a) of two adjacent data signal lines DL is taken as a plane of symmetry, and the third pixel opening 613 is mirror-symmetric. With this design, it is possible to improve the uniformity of the arrangement of the third pixel openings 613 and the data signal lines DL, thereby further ensuring the display quality of the display panel 100.

Hereinafter, the structures of the first via hole 71 and the second via hole 91 in the display panel 100 will be schematically described with reference to FIG. 3.

In some embodiments, referring to FIG. 3, the second via hole 91 is formed in the second planarization layer 9 that is closer to the pixel definition layer 6 than the first planarization layer 7, and a distance between an orthogonal projection of a border of the second via hole 91 on the substrate 1 and an orthogonal projection of a border of a pixel opening 61 on the substrate 1 is less than an orthogonal projection of a border of the first via hole 71 on the substrate 1 and the orthogonal projection of the border of the pixel opening 61 on the substrate 1. In this case, the second via hole 91 needs to be manufactured near the portion of the first electrode 31 exposed by the pixel opening 61, so that the portion is inclined to a certain extent caused by a case that the portion is located at a transition region between a flat surface and a concave surface. As a result, the planarization of the portion is reduced, which results in a harmful effect on the planarization of the light-emitting functional layer 4 disposed on the portion, thereby reducing the light-emitting uniformity of the display panel 100 as a whole.

On this basis, the orthogonal projection of the border of the second via hole 91 on the substrate 1 may at least partially overlaps with, for example, the orthogonal projection of the border of the pixel opening 61 on the substrate 1. In this case, since the second via hole 91 is exactly located at the portion of the first electrode 31 exposed by the pixel opening 61, which results in a more harmful effect on the planarization of the portion. That is, it results in a more harmful effect on the light-emitting uniformity of the display panel 100 as a whole.

In light of this, in some embodiments of the present disclosure, referring to FIG. 18, in a sub-pixel region P, a minimum distance between an orthogonal projection of a border of the first via hole 71 on the substrate 1 and an orthogonal projection of a border of a pixel opening 61 on the substrate 1 is less than a minimum distance between an orthogonal projection of a border of the second via hole 91 on the substrate 1 and the orthogonal projection of the border of the pixel opening 61 on the substrate 1.

In some of the above embodiments, in a same sub-pixel region P, the second via hole 91 is farther away from the pixel opening 61 than the first via hole 71, which prevents the portion of the first electrode 31 exposed by the pixel opening 61 from being affected by the second via hole 91, so as to ensure the planarization of the portion and further avoid a harmful effect on the light-emitting functional layer 4 disposed on the portion, thereby improving the light-emitting uniformity of the display panel 100 as a whole. It will be noted that, although the first via hole 71 is closer to the pixel opening 61 than the second via hole 91, the first via hole 71 does not affect the planarization of the portion of the first electrode 31 exposed by the pixel opening 61 because the first via hole 71 is covered with the second planarization layer 9, and the second planarization layer 9 is able to planarize the first via hole 71.

In some examples, with continued reference to FIG. 18, the first via hole 71 and the second via hole 91 are located on a same side of the pixel opening 61.

In some examples, with continued reference to FIG. 18, in the sub-pixel region P, the orthogonal projection of the border of the first via hole 71 on the substrate 1 is non-overlapping with the orthogonal projection of the border of the second via hole 91 on the substrate 1. In the sub-pixel region P, a minimum distance between the orthogonal projection of the border of the first via hole 71 on the substrate 1 and the orthogonal projection of the border of the second via hole 91 on the substrate 1 may be, for example, not less than 1.3 µm.

In some of the above examples, in the same sub-pixel region P, by limiting the minimum distance between the orthogonal projection of the border of the first via hole 71 on the substrate 1 and the orthogonal projection of the border of the second via hole 91 on the substrate 1 to be not less than 1.3 µm, it is possible to prevent the distance between the orthogonal projection of the border of the first via hole 71 on the substrate 1 and the orthogonal projection of the border of the second via hole 91 on the substrate 1 from being too close, which avoids a situation that an exposure position shifts caused by the second planarization layer 9 that is relatively thick and located exactly above the first via hole 71, thereby ensuring that a contact area between the first electrode 31 and the conductive connection layer 8 is sufficient, and avoiding an occurrence of an open circuit.

For example, the orthogonal projection of the border of the first via hole 71 on the substrate 1 is in a shape of a rectangle-like, a circle or an ellipse. With this design, it is possible to make the shape of the first via hole 71 more regular, thereby reducing the difficulty of manufacturing the conductive connection layer 8 on the side of the first via hole 71 away from the substrate 1.

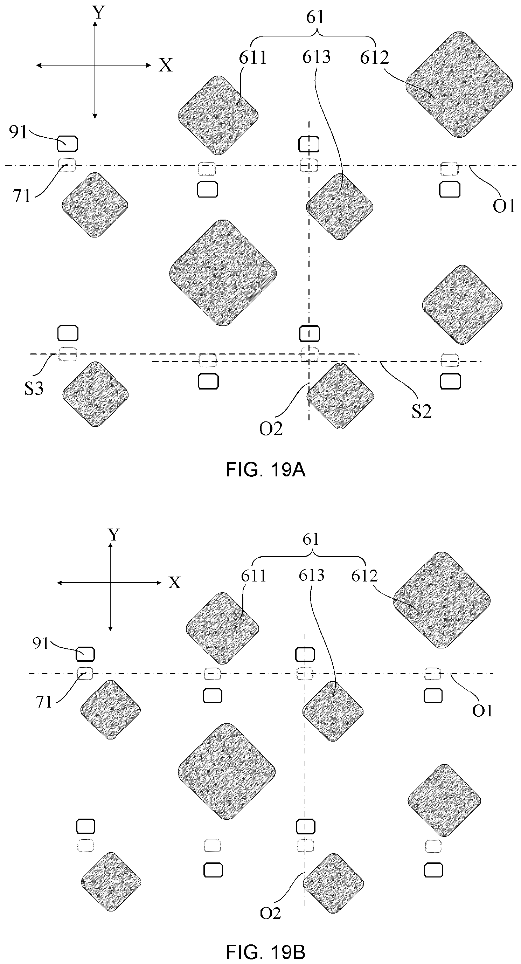

It will be noted that in a case where the orthogonal projection of the border of the first via hole 71 on the substrate 1 is in the shape of the rectangle-like, corners of the rectangle-like may be each a round corner as shown in FIG. 19A or a right-angled corner.

For example, a depth of the first via hole 71 is in a range from 1.6 µm to 2 µm. With this design, the consistency of the first via hole 71 during exposure and the uniformity of the first via hole 71 during etching may be both improved.

For example, the orthogonal projection of the border of the second via hole 91 on the substrate 1 is in a shape of a rectangle-like, a circle or an ellipse. With this design, it is possible to make the shape of the second via hole 91 more regular, thereby reducing the difficulty of manufacturing the first electrode layer 3 on the side of the second via hole 91 away from the substrate 1.

It will be noted that in a case where the orthogonal projection of the border of the second via hole 91 on the substrate 1 is in the shape of the rectangle-like, corners of the quasi-rectangle may be each a round corner as shown in FIG. 19A or a right-angled corner.

For example, a depth of the second via hole 91 is in a range from 1.6 µm to 2 µm. With this design, the consistency of the second via hole 91 during exposure and the uniformity of the second via hole 91 during exposure may be both improved.

In some embodiments, referring to FIG. 17, metal film layers respectively below all of the first via holes 71 are substantially the same.

In some of the above embodiments, by controlling the metal film layers respectively below all of the first via holes 71 to be substantially the same, it is possible to improve the consistency of each first via hole 71 during exposure and the uniformity of each first via hole 71 during etching.

In some examples, with continued reference to FIG. 17, metal film layers below the second via hole 91 corresponding to the first pixel opening 611 and metal film layers below the second via hole 91 corresponding to the second pixel opening 612 are substantially the same.

In some of the above examples, by controlling the metal film layers below the second via hole 91 corresponding to the first pixel opening 611 and the metal film layers below the second via hole 91 corresponding to the second pixel opening 612 to be substantially the same, it is possible to improve the consistency of the second via hole 91 during exposure and the uniformity of the second via hole 91 during etching.

In some examples, with continued reference to FIG. 17, metal film layers respectively below all of second via holes 91 corresponding to the third pixel openings 613 are substantially the same.

In some of the above examples, by controlling the metal film layers respectively below all of the second via holes 91 corresponding to the third pixel openings 613 to be substantially the same, it is possible to improve the consistency of the second via hole 91 during exposure and the uniformity of the second via hole 91 during etching.

In some embodiments, with continued reference to FIGS. 18 and 19A, a shape and a size of the first via hole 71 in the sub-pixel region P where the first pixel opening 611 is located are substantially the same as a shape and a size of the first via hole 71 in the sub-pixel region P where the second pixel opening 612 is located, respectively; and/or a shape and a size of the second via hole 91 in the sub-pixel region P where the first pixel opening 611 is located are substantially the same as a shape and a size of the second via hole 91 in the sub-pixel region P where the second pixel opening 612 is located, respectively; and/or a shape and a size of the first via hole 71 in the sub-pixel region P where the third pixel opening 613 is located and a shape and a size of the first via hole 71 in the sub-pixel region P where the adjacent third pixel opening 613 is located are substantially the same, respectively; and/or a shape and a size of the second via hole 91 in the sub-pixel region P where the third pixel opening 613 is located and a shape and a size of the second via hole 91 in the sub-pixel region P where the adjacent third pixel opening 613 is located are substantially the same, respectively.

In some of the above embodiments, the shape and the size of the first via hole 71 (or the second via hole 91) in the sub-pixel region P where the first pixel opening 611 is located are substantially the same as the shape and the size of the first via hole 71 (or the second via hole 91) in the sub-pixel region P where the second pixel opening 612 is located, respectively, and the shape and the size of the first via hole 71 (or the second via hole 91) in the sub-pixel region P where the third pixel openings 613 is located are substantially the same as the shape and the size of the first via hole 71 (or the second via hole 91) in the sub-pixel region P where the adjacent third pixel openings 613 is located, respectively, so that it is possible to improve the consistency of the first via hole 71 (or the second via hole 91) during exposure and the uniformity of the first via hole 71 (or the second via hole 91) during etching.

In some examples, referring to FIG. 18, the border of the first via hole 71 in the sub-pixel region P where the first pixel opening 611 is located defines a first region M1, and the border of the first via hole 71 in the sub-pixel region P where the second pixel opening 612 is located defines a second region M2; in all of the metal layers 22, a total thickness of a portion located in the first region M1 is approximately equal to a total thickness of a portion located in the second region M2.

For example, with continued reference to FIG. 18, in all of the metal layers 22, the total number of layers of the portion located in the first region M1 is equal to the total number of layers of the portion located in the second region M2.

For example, with continued reference to FIG. 18, in all of the metal layers 22, the total number of layers of the portion located in the first region M1 and the total number of layers of the portion located in the second region M2 are each one.

For example, with continued reference to FIG. 18, in all of the metal layers 22, a shape and a size of the portion located in the first region M1 are substantially the same as a shape and a size of the portion located in the second region M2, respectively.

In some of the above examples, in all of the metal layers 22, the total thickness and the total number of layers of the portion located in the first region M1 are respectively equal to the total thickness and the total number of layers of the portion located in the second region M2, and the shape and the size of the portion located in the first region M1 are respectively the same as the shape and the size of the portion located in the second region M2, so that a thickness of the metal film layer below the first via hole 71 in the sub-pixel region P where the first pixel opening 611 is located is approximately equal to a thickness of the metal film layer below the first via hole 71 in the sub-pixel region P where the second pixel opening 612 is located. As a result, it is possible to achieve that the shape and the size of the first via hole 71 in the sub-pixel region P where the first pixel opening 611 is located are substantially the same as the shape and the size of the first via hole 71 in the sub-pixel region P where the second pixel opening 612 is located, respectively, thereby improving the consistency of the first via hole 71 during exposure and the uniformity of the first via hole 71 during etching.

In some examples, with continued reference to FIG. 18, the border of the second via hole 91 in the sub-pixel region P where the first pixel opening 611 is located defines a third region M3, and the border of the second via hole 91 in the sub-pixel region P where the second pixel opening 612 is located defines a fourth region M4; in all of the metal layers 22, a total thickness of a portion located in the third region M3 is approximately equal to a total thickness of a portion located in the fourth region M4.

For example, with continued reference to FIG. 18, in all of the metal layers 22, the total number of layers of the portion located in the third region M3 is equal to the total number of layers of the portion located in the fourth region M4.

For example, with continued reference to FIG. 18, in all of the metal layers 22, the total number of layers of the portion located in the third region M3 and the total number of layers of the portion located in the fourth region M4 are each two.

For example, with continued reference to FIG. 18, in all of the metal layers 22, a shape and a size of the portion located in the third region M3 are substantially the same as a shape and a size of the portion located in the second region M4, respectively.

In some of the above examples, in all of the metal layers 22, the total thickness and the total number of layers of the portion located in the third region M3 are respectively equal to the total thickness and the total number of layers of the portion located in the fourth region M4, and the shape and the size of the portion located in the third region M3 are respectively the same as the shape and the size of the portion located in the fourth region M4, so that a thickness of metal film layers below the second via hole 91 in the sub-pixel region P where the first pixel opening 611 is located is approximately equal to a thickness of metal film layers below the second via hole 91 in the sub-pixel region P where the second pixel opening 612 is located. As a result, it is possible to achieve that the shape and the size of the second via hole 91 in the sub-pixel region P where the first pixel opening 611 is located are substantially the same as the shape and the size of the second via hole 91 in the sub-pixel region P where the second pixel opening 612 is located, respectively, thereby improving the consistency of the second via hole 91 during exposure and the uniformity of the second via hole 91 during etching.

In some examples, with continued reference to FIG. 18, the border of the first via hole 71 in the sub-pixel region P where the third pixel opening 613 is located defines a fifth region M5; in all of the metal layers 22, total thicknesses of two portions respectively located in two adjacent fifth regions M5 are approximately equal.

For example, with continued reference to FIG. 18, in all of the metal layers 22, the total numbers of layers of the two portions respectively located in the two adjacent fifth regions M5 are equal.

For example, with continued reference to FIG. 18, in all of the metal layers 22, the total numbers of layers of the two portions respectively located in the two adjacent fifth regions M5 are each one.

For example, with continued reference to FIG. 18, in all of the metal layers 22, shapes and sizes of the two portions respectively located in the two adjacent fifth regions M5 are substantially the same, respectively.

In some of the above examples, in all of the metal layers 22, the total thicknesses and the total numbers of layers of the two portions respectively located in the two adjacent fifth regions M5 are respectively equal, and the shapes and the sizes of the two portions respectively located in the two adjacent fifth regions M5 are respectively the same, so that a thicknesses of the metal film layer below the first via hole 71 in the sub-pixel region P where the third pixel opening 613 is located are approximately equal to a thicknesses of the metal film layer below the first via hole 71 in the sub-pixel region P where the adjacent third pixel opening 613 is located. As a result, it is possible to h achieve that the shape and the size of the first via hole 71 in the sub-pixel region P where the third pixel opening 613 is located are substantially the same as the shape and the size of the first via hole 71 in the sub-pixel region P where the adjacent third pixel opening 613 is located, respectively, thereby improving the consistency of the first via hole 71 during exposure and the uniformity of the first via hole 71 during etching.

In some examples, with continued reference to FIG. 18, the border of the second via hole 91 in the sub-pixel region P where the third pixel opening 613 is located defines a sixth region M6; in all of the metal layers 22, total thicknesses of two portions respectively located in two adjacent sixth regions M6 are approximately equal.

For example, with continued reference to FIG. 18, in all of the metal layers 22, the total numbers of layers of the two portions respectively located in the two adjacent sixth regions M6 are equal.

For example, with continued reference to FIG. 18, in all of the metal layers 22, the total numbers of layers of the two portions respectively located in the two adjacent sixth regions M6 are each two.

For example, with continued reference to FIG. 18, in all of the metal layers 22, shapes and sizes of the two portions respectively located in the two adjacent sixth regions M6 are substantially the same, respectively.

In some of the above examples, in all of the metal layers 22, the total thicknesses and the total numbers of layers of the two portions respectively located in the two adjacent sixth regions M6 are respectively equal, and the shapes and the sizes of the two portions respectively located in the two adjacent sixth regions M6 are respectively the same, so that a thickness of metal film layers below the second via hole 91 in the sub-pixel region P where the third pixel opening 613 is located are approximately equal to a thickness of metal film layers below the second via hole 91 in the sub-pixel region P where the adjacent third pixel opening 613 is located. As a result, it is possible to achieve that the shape and the size of the second via hole 91 in the sub-pixel region P where the third pixel opening 613 is located are substantially the same as the shape and the size of the second via hole 91 in the sub-pixel region P where the adjacent third pixel opening 613 is located, respectively, thereby improving the consistency of the second via hole 91 during exposure and the uniformity of the second via hole 91 during etching.

In some embodiments, referring to FIG. 19A, in the two adjacent rows of pixel openings 61, first via holes 71 respectively corresponding to all pixel openings 61 are arranged on a straight line O1 extending in the first direction X, and second via holes 91 respectively corresponding to all pixel openings 61 are alternately arranged, in the first direction X, on both sides of the straight line O1 extending in the first direction X.

In some examples, referring to FIG. 19B, in the two adjacent rows of pixel openings 61, geometric centers of the first via holes 71 respectively corresponding to all pixel openings 61 are arranged on the straight line O1 extending in the first direction X, and the second via holes 91 respectively corresponding to all pixel openings 61 are alternately arranged, in the first direction X, on the both sides of the straight line O1 extending in the first direction X.

In some examples, referring to FIG. 19A, in the two adjacent rows of pixel openings 61, the first via holes 71 respectively corresponding to all the pixel openings 61 are each located at a same position in a respective pixel driving circuit 21, and the second via holes 91 respectively corresponding to the first pixel openings 611 and the second via holes 91 respectively corresponding to the second pixel openings 612 are each located at a same position in a respective pixel driving circuit 21.

For example, with continued reference to FIG. 19A, second via holes 91 respectively corresponding to all third pixel openings 613 are each located at a same position in a respective pixel driving circuit 21.

In some of the above examples, by limiting a relationship of positions, in respective pixel driving circuits 21, of the first via holes 71 and the second via holes 91 respectively corresponding to all pixel openings 61 in the two adjacent rows of pixel openings 61, in the two adjacent rows of pixel openings 61, the metal film layer below the first via hole 71 corresponding to each pixel opening 61 has an approximately equal thickness, the total thickness of the metal film layers below the second via hole 91 corresponding to the first pixel opening 611 is approximately equal to the total thickness of the metal film layers below the second via hole 91 corresponding to the second pixel opening 612, and total thicknesses of metal film layers respectively below the second via holes 91 respectively corresponding to all the third pixel openings 613 are approximately equal, thereby improving the consistency of the first via hole 71 and the second via hole 91 during exposure and the uniformity of the first via hole 71 and the second via hole 91 during etching.

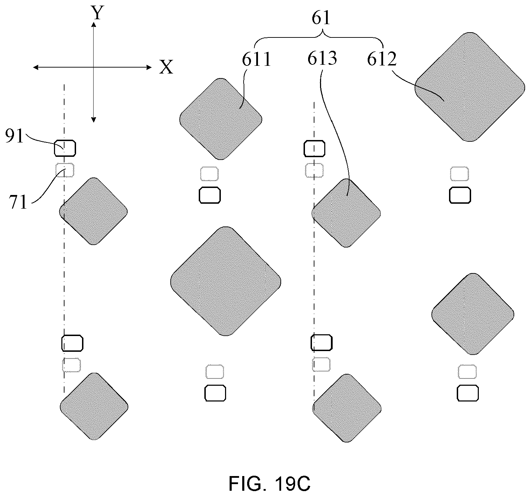

In some embodiments, referring to FIG. 19C, in the two adjacent rows of pixel openings 61, positions of the first via holes 71 respectively corresponding to all the pixel openings 61 are different in the second direction Y

On this basis, the display panel 100 further includes light-emitting control signal lines located in the first gate layer and extending in the first direction X, an orthogonal projection of each first via hole 71 on the substrate 1 and an orthographic projection of a respective light-emitting control signal line on the substrate 1 have an approximately equal overlapping area.

In some embodiments, referring to FIG. 19A, in a same column of pixel openings 61, first via holes 71 respectively corresponding to all pixel openings 61 and second via holes 91 respectively corresponding to all pixel openings 61 are arranged on a straight line 02 extending in the second direction Y

In some examples, referring to FIG. 19A, geometric centers of the first via holes 71 respectively corresponding to the first pixel opening 611 and the second pixel opening 612 that are arranged in the first direction X and adjacent to each other are connected to form a second virtual straight line S2; geometric centers of the first via holes 71 respectively corresponding to the two second pixel openings 613 that are arranged in the first direction X and adjacent to each other are connected to form a third virtual straight line S3; an angle between the second virtual straight line S2 and the third virtual straight line S3 is in a range from 0° to 30°.

For example, referring to FIG. 19A, in a case where the second virtual straight line S2 is parallel to the third virtual straight line S3, a distance between the second virtual straight line S2 and the third virtual straight line S3 is less than a dimension of the first via hole 71 in the second direction Y

In some embodiments, referring to FIG. 19A, in the same row of pixel openings 61, the first via holes 71 respectively corresponding to all the pixel openings 61 are sequentially arranged in the first direction X, and/or the second via holes 91 respectively corresponding to all the pixel openings 61 are sequentially arranged in the first direction X.

It will be noted that the first via holes 71 (or the second via holes 91) are sequentially arranged in the first direction X. In this case, in the same row of pixel openings 61, centers of the first via holes 71 (or the second via holes 91) respectively corresponding to all the pixel openings 61 may be, for example, located on a same straight line or not located on a same straight line.

For example, with continued reference to FIG. 19A, there may be no distance, in the second direction Y, between centers of first via holes 71 in the same row (that is, the centers of the first via holes 71 in the same row are located on a same straight line); and/or there may be no distance, in the second direction Y, between centers of second via holes 91 in the same row (that is, the centers of the second via holes 91 in the same row are located on a same straight line).

For another example, there may be a certain distance, in the second direction Y, between centers of the first via holes 71 in the same row (that is, the centers of the first via holes 71 in the same row are not located on a same straight line), and the distance may be, for example, less than or equal to half of the dimension of the first via hole 71 in the second direction Y; and/or there may be a certain distance, in the second direction Y, between centers of the second via holes 91 in the same row (that is, the centers of the second via holes 91 in the same row are not located on a same straight line), and the distance may be, for example, less than or equal to half of a dimension of the second via hole 91 in the second direction Y

For example, with continued reference to FIG. 19A, in the two adjacent rows of pixel openings 61, the first via holes 71 respectively corresponding to all the pixel openings 61 are sequentially arranged in the same first direction X.

It will be noted that the first via holes 71 are sequentially arranged in the first direction X. In this case, in the same row of pixel openings 61, the centers of the first via holes 71 respectively corresponding to all the pixel openings 61 may be, for example, located on a same straight line or not located on a same straight line.

For example, with continued reference to FIG. 19A, there may be a certain distance, in the second direction Y, between centers of the first via holes 71 in the same row (that is, the centers of the first via holes 71 in the same row are not located on a same straight line), and the distance may be, for example, less than or equal to the half of the dimension of the first via hole 71 in the second direction Y

For example, there may be no distance, in the second direction Y, between centers of the first via holes 71 in the same row (that is, the centers of the first via holes 71 in the same row are located on a same straight line).

In some of the above examples, the first via holes 71 (or the second via holes 91) respectively corresponding to all the pixel openings 61 in the same row of pixel openings 61 are sequentially arranged in the first direction X, and even there is no distance between the centers of the first via holes 71 (or the second via holes 91) in the same row in the second direction Y, so that in all of the metal layers 22, the shape and the size of the portion located in the first region M1 and the shape and the size of the portion located in the second region M2 that is in the same row as the first region M1 (or the shape and the size of the portion located in the third region M3 and the shape and the size of the portion located in the fourth region M4 that is in the same row as the third region M3) are substantially the same, respectively; and shapes and sizes of portions respectively located in fifth regions M5 in the same row (or portions respectively located in sixth regions M6 in the same row) are substantially the same, respectively. Therefore, the thicknesses of metal film layers respectively below the first via holes 71 (or the second via holes 91) in the same row are approximately equal, and the shapes and the sizes of the first via holes 71 (or the second via holes 91) in the same row are substantially the same, respectively, thereby further improving the consistency of the first via hole 71 and the second via hole 91 during exposure and the uniformity of the first via hole 71 and the second via hole 91 during etching.

In some examples, with continued reference to FIG. 19A, in the same column of pixel openings 61, the first via holes 71 respectively corresponding to all pixel openings 61 are sequentially arranged in the second direction Y, and/or the second via holes 91 respectively corresponding to all the pixel openings 61 are sequentially arranged in the second direction Y

It will be noted that the first via holes 71 (or the second via holes 91) are sequentially arranged in the second direction Y In this case, in the same column of pixel openings 61, centers of the first via holes 71 (or the second via holes 91) respectively corresponding to all the pixel openings 61 may be, for example, located on a same straight line or not located on a same straight line.

For example, with continued reference to FIG. 19A, there may be no distance, in the first direction X, between centers of the first via holes 71 in the same column (that is, the centers of the first via holes 71 in the same column are located on a same straight line); and/or there may be no distance, in the first direction X, between centers of the second via holes 91 in the same column (that is, the centers of the second via holes 91 in the same column are located on a same straight line).

For another example, there may be a certain distance, in the first direction X, between centers of the first via holes 71 in the same column (that is, the centers of the first via holes 71 in the same column are not located on a same straight line), and the distance may be, for example, less than or equal to half of a dimension of the first via hole 71 in the first direction X; and/or there may be a certain distance, in the first direction X, between centers of the second via holes 91 in the same column (that is, the centers of the second via holes 91 in the same column are not located on a same straight line), and the distance may be, for example, less than or equal to half of a dimension of the second via hole 91 in the first direction X.

In some of the above examples, the first via holes 71 (or the second via holes 91) respectively corresponding to all the pixel openings 61 in the same column of pixel openings 61 are controlled to be sequentially arranged in the second direction Y, and even there is on distance between the centers of the first via holes 71 (or the second via holes 91) in the same row in the first direction X so that in all of the metal layers 22, the shape and the dimension of the portion located in the first region M1 and the shape and the size of the portion located in the second region M2 that is in the same column as the first region M1 (or the shape and the size of the portion located in the third region M3 and the shape and the size of the portion located in the fourth region M4 that is in the same column as the third region M3) are substantially the same, respectively; and the shapes and the sizes of the portions respectively located in fifth regions M5 in the same column (or the portions respectively located in the sixth regions M6 in the same column) are substantially the same, respectively. Therefore, the thicknesses of metal film layers respectively below the first via holes 71 (or the second via holes 91) in the same column are approximately equal, and the shapes and the sizes of the first via holes 71 (or the second via holes 91) in the same column are substantially the same, respectively, thereby further improving the consistency of the first via hole 71 and the second via hole 91 during exposure and the uniformity of the first via hole 71 and the second via hole 91 during etching.

It will be noted that the center of the first via hole 71 may be, for example, the geometric center of the first via hole 71; the center of the second via hole 91 may be, for example, the geometric center of the second via hole 91.

Therefore, in some of the above embodiments, in the same sub-pixel region P, firstly, the second via hole 91 is farther away from the pixel opening 61 than the first via hole 71, which prevents the portion of the first electrode 31 located in a region defined with the pixel opening 61 from being affected by the second via hole 91, so as to ensure the planarization of the portion and further avoid the harmful effect on the light-emitting functional layer 4 disposed on the portion, thereby improving the light-emitting uniformity of the display panel 100 as a whole; furthermore, by limiting the minimum distance between the orthogonal projection of the border of the first via hole 71 on the substrate 1 and the orthogonal projection of the border of the second via hole 91 on the substrate 1, it is possible to prevent the distance between the orthogonal projection of the border of the first via hole 71 on the substrate 1 and the orthogonal projection of the border of the second via hole 91 on the substrate 1 from being too close, which avoids the situation that the exposure position shifts caused by the second planarization layer 9 that is relatively thick and located exactly above the first via hole 71, thereby ensuring that the contact area between the first electrode 31 and the conductive connection layer 8 is sufficient, and avoiding the occurrence of the open circuit.

In addition, the shape and the size of the first via hole 71 (or the second via hole 91) in the sub-pixel region P where the first pixel opening 611 is located are respectively substantially the same as the shape and the size of the first via hole 71 (or the second via hole 91) in the sub-pixel region P where the second pixel opening 612 is located, and the shapes and the sizes of the first via holes 71 (or the second via holes 91) respectively in the two sub-pixel regions P where the two adjacent third pixel openings 613 are respectively located are respectively substantially the same, it is possible to improve the consistency of the first via hole 71 (or the second via hole 91) during exposure and the uniformity of the first via hole 71 (or the second via hole 91) during etching.

Some other embodiments of the present disclosure provide a display panel 100, and the display panel 100 may be applied to the display apparatus 1000. Of course, the display panel 100 may be applied to other apparatuses. Referring to FIG. 18, the display panel 100 includes a substrate 1, and a circuit structure layer 2, a first planarization layer 7, a conductive connection layer 8, a second planarization layer 9, a first electrode layer 3 and a pixel definition layer 6 that are located on a side of the substrate 1 and sequentially away from the substrate 1.

The circuit structure layer 2 includes a plurality of pixel driving circuits 21; the first planarization layer 7 has a plurality of first via holes 71 therein; the conductive connection layer 8 includes a plurality of conductive portions 81; the second planarization layer 9 has a plurality of second via holes 91 therein; the first electrode layer 3 includes a plurality of first electrodes 31; and the pixel definition layer 6 has a plurality of pixel openings 61 therein.

The display panel 100 has a plurality of sub-pixel regions P. In a sub-pixel region, a pixel opening 61 exposes at least a portion of a first electrode 31, the first electrode 31 is electrically connected to a conductive portion 81 through a second via hole 91, and the conductive portion 81 is electrically connected to a pixel driving circuit 21 through a first via hole 71; a minimum distance between an orthogonal projection of a border of the first via hole 71 on the substrate 1 and an orthogonal projection of a border of the pixel opening 61 on the substrate 1 is less than a minimum distance between an orthogonal projection of a border of the second via hole 91 on the substrate 1 and the orthogonal projection of the border of the pixel opening 61 on the substrate 1.

In these embodiments, in a same sub-pixel region P, the second via hole 91 is farther away from the pixel opening 61 than the first via hole 71, which prevents a portion of the first electrode 31 exposed by the pixel opening 61 from being affected by the second via hole 91, so as to ensure the planarization of the portion and further avoid a harmful effect on a light-emitting functional layer 4 disposed on the portion, thereby improving the light-emitting uniformity of the display panel 100 as a whole. It will be noted that, although the first via hole 71 is closer to the pixel opening 61 than the second via hole 91, the first via hole 71 does not affect the planarization of the portion of the first electrode 31 exposed by the pixel opening 61 because the first via hole 71 is covered with the second planarization layer 9, and the second planarization layer 9 is able to planarize the first via hole 71.

It will be noted that the display panel 100 provided in the some other embodiments of the present disclosure may further be combined with any of the above embodiments, and details will not be repeated here.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate;
a circuit structure layer located on a side of the substrate and including a plurality of pixel driving circuits; the plurality of pixel driving circuits being arranged in a first direction to constitute pixel driving circuit rows, and the pixel driving circuit rows being sequentially arranged in a second direction; the first direction intersecting the second direction;
a first electrode layer located on a side of the circuit structure layer away from the substrate and including a plurality of first electrodes; a first electrode being electrically connected to a pixel driving circuit; and
a pixel definition layer located on a side of the first electrode layer away from the substrate and having a plurality of pixel openings therein; a pixel opening exposing at least a portion of a respective first electrode;
wherein the pixel driving circuits each include a driving transistor and a data compensation transistor;
an orthographic projection of at least one first electrode on the substrate at least partially overlaps with both of an orthographic projection, on the substrate, of a gate of a data compensation transistor in a pixel driving circuit corresponding to the first electrode and an orthographic projection, on the substrate, of a gate of a data compensation transistor in at least one pixel driving circuit adjacent to the pixel driving circuit corresponding to the first electrode;
an orthogonal projection, on the substrate, of a pixel opening corresponding to the at least one first electrode is spaced apart from the orthographic projection, on the substrate, of the gate of the data compensation transistor in the pixel driving circuit corresponding to the first electrode; and
for a first electrode of the at least one first electrode, an orthographic projection, on the substrate, of the data compensation transistor corresponding to the first electrode and a first virtual straight line extending in the first direction have a first overlapping portion; an orthographic projection, on the substrate, of a data compensation transistor in a pixel driving circuit adjacent to a pixel driving circuit corresponding to the first electrode and the first virtual straight line have a second overlapping portion; a distance, in the first direction, between the first overlapping portion and the second overlapping portion is greater than a dimension, in the first direction, of a pixel opening corresponding to the first overlapping portion.

2. The display panel according to claim 1, wherein
the plurality of pixel openings are arranged in a plurality of rows and a plurality of columns, and two adjacent rows of pixel openings are staggered from one another in the first direction;
in two adjacent rows of pixel openings, a row of pixel openings include first pixel openings and second pixel openings that are alternately arranged in the first direction, and another row of pixel openings include third pixel openings sequentially arranged in the first direction; and
in two adjacent columns of pixel openings, a column of pixel openings include first pixel openings and second pixel openings that are alternately arranged in the second direction, and another column of pixel openings include third pixel openings sequentially arranged in the second direction;
wherein an area of a first pixel opening is less than an area of a second pixel opening, and the area of the first pixel opening is greater than an area of a third pixel opening.

3. The display panel according to claim 2, wherein
in any row of pixel openings including first pixel openings and second pixel openings that are alternately arranged, any first pixel opening has an equal distance to two second pixel openings adjacent to the any first pixel opening; and
in any column of pixel openings including first pixel openings and second pixel openings that are alternately arranged, any first pixel opening has distances, that are not equal, to two second pixel openings adjacent to the any first pixel opening, respectively.

4. The display panel according to claim 2 or 3, wherein
geometrical centers of a first pixel opening and a second pixel opening that are adjacent to each other in a column of pixel openings, and geometrical centers of a first pixel opening and a second pixel opening that are adjacent to each other in an adjacent column of pixel openings are sequentially connected to form a virtual trapezoid.

5. The display panel according to any one of claims 2 to 4, wherein
in a same row of pixel openings, a center of a first pixel opening and a center of a second pixel opening have a distance in the second direction therebetween.

6. The display panel according to claim 5, wherein
the distance is less than or equal to half of a dimension of the first pixel opening in the second direction.

7. The display panel according to any one of claims 2 to 6, wherein
an orthographic projection, on the substrate, of a first electrode corresponding to the first pixel opening at least partially overlaps with both of an orthographic projection, on the substrate, of a gate of a data compensation transistor in a pixel driving circuit corresponding to the first electrode, and an orthographic projection, on the substrate, of a gate of a data compensation transistor in at least one pixel driving circuit adjacent to the pixel driving circuit corresponding to the first electrode; and/or
an orthographic projection, on the substrate, of a first electrode corresponding to the second pixel opening at least partially overlaps with both of an orthographic projection, on the substrate, of a gate of a data compensation transistor in a pixel driving circuit corresponding to the first electrode, and an orthographic projection, on the substrate, of a gate of a data compensation transistor in at least one pixel driving circuit adjacent to the pixel driving circuit corresponding to the first electrode.

8. The display panel according to any one of claims 2 to 7, wherein
an orthogonal projection of the first pixel opening on the substrate is spaced apart from an orthographic projection, on the substrate, of a gate of a data compensation transistor in a pixel driving circuit corresponding to the first pixel opening; and/or
an orthogonal projection of the third pixel opening on the substrate is spaced apart from an orthographic projection, on the substrate, of a gate of a data compensation transistor in a pixel driving circuit corresponding to the third pixel opening.

9. The display panel according to any one of claims 2 to 8, wherein
first pixel openings and third pixel openings are alternately arranged in a third direction constitute first groups of pixel openings, second pixel openings and third pixel openings are alternately arranged in the third direction constitute second groups of pixel openings, and the first groups of pixel openings and the second groups of pixel openings are alternately arranged in a fourth direction; the third direction intersects the fourth direction;
wherein in a first group of pixel openings, an orthographic projection, on the substrate, of a first electrode corresponding to a first pixel opening at least partially overlaps with an orthographic projection, on the substrate, of a gate of a data compensation transistor in a pixel driving circuit corresponding to a third pixel opening adjacent to the first pixel opening; and
in a second group of pixel openings, an orthographic projection, on the substrate, of a first electrode corresponding to a second pixel opening at least partially overlaps with an orthographic projection, on the substrate, of a gate of a data compensation transistor corresponding to another third pixel opening adjacent to the second pixel opening.

10. The display panel according to claim 9, wherein
orthographic projections, on the substrate, of two first electrodes respectively corresponding to a first pixel opening and a second pixel opening that are adjacent to each other at least partially overlap with orthographic projections, on the substrate, of gates of data compensation transistors respectively corresponding to two third pixel openings that are located on a same side of the first pixel opening and the second pixel opening that are adjacent to each other, respectively.

11. The display panel according to any one of claims 2 to 10, wherein
the display panel has a display region; pixel openings closest to a border of the display region includes at least one row of pixel openings including first pixel openings and second pixel openings that are alternately arranged in the first direction, and/or at least one column of pixel openings including first pixel openings and second pixel openings that are alternately arranged in the second direction.

12. The display panel according to any one of claims 2 to 11, wherein
the first pixel opening is configured to define an effective light-emitting region of first-color light, the second pixel opening is configured to define an effective light-emitting region of second-color light, and the third pixel opening is configured to define an effective light-emitting region of third-color light;
the first-color light is red light, the second-color light is blue light, and the third-color light is green light.

13. The display panel according to any one of claims 2 to 12, wherein
the circuit structure layer includes an active layer, a first gate layer, a second gate layer and a source-drain electrode layer that are sequentially away from the substrate;
the display panel further comprises a conductive connection layer located between the circuit structure layer and the first electrode layer; and
the display panel comprises a plurality of reset signal lines for providing reset signals for the first electrodes, the plurality of reset signal lines include:
first reset signal lines located in the second gate layer or the active layer and extending in the first direction; and second reset signal lines located in the source-drain electrode layer or the conductive connection layer and extending in the second direction;
wherein an orthographic projection of a first reset signal line on the substrate overlaps with an orthographic projection of the second reset signal line on the substrate, and at a position where the orthographic projection of the first reset signal line on the substrate overlaps with the orthographic projection of the second reset signal line on the substrate, the first reset signal line is electrically connected to the second reset signal line through a via hole;
in a case where the first reset signal line is located in the second gate layer and the second reset signal line is located in the source-drain electrode layer, the second reset signal line is connected to the active layer through another via hole.

14. The display panel according to claim 13, wherein the display panel further comprises a plurality of power supply signal lines, the plurality of power supply signal lines include:
a first power supply signal line located in the source-drain electrode layer and extending in the second direction, and a second power supply signal line located in the conductive connection layer and extending in the second direction;
wherein the first power supply signal line is electrically connected to the second power supply signal line, an orthographic projection of the first power supply signal line on the substrate overlaps with an orthographic projection of the second power supply signal line on the substrate, and an orthogonal projection of at least one pixel opening on the substrate is located within the orthographic projection of the second power supply signal line on the substrate.

15. The display panel according to claim 14, wherein
the second power supply signal line has a plurality of protruding portions, and an orthographic projection of a protruding portion on the substrate at least partially overlaps with an orthogonal projection, on the substrate, of the pixel opening corresponding to the respective first electrode.

16. The display panel according to claim 13, further comprising:
a plurality of data signal lines located in the conductive connection layer and extending in the second direction, the plurality of data signal lines being sequentially arranged in the first direction; wherein
the first pixel opening, the second pixel opening and the third pixel opening are configured to be arranged in at least one of following manners:
an orthogonal projection of the first pixel opening on the substrate is located between orthographic projections of two adjacent data signal lines on the substrate; or
an orthogonal projection of the second pixel opening on the substrate is located between an orthographic projection of another two adjacent data signal lines on the substrate; or the orthographic projections of the another two adjacent data signal lines on the substrate each partially overlap with the orthogonal projection of the second pixel opening on the substrate, and an area of an overlapping portion of an orthographic projection of one of the another two adjacent data signal lines on the substrate and the orthogonal projection of the second pixel opening on the substrate is approximately equal to an area of an overlapping portion of an orthographic projection of another of the another two adjacent data signal lines on the substrate and the orthogonal projection of the second pixel opening on the substrate; or
an orthogonal projection of the third pixel opening on the substrate is located between orthographic projections of yet another two adjacent data signal lines on the substrate.

17. The display panel according to claim 16, wherein
the first pixel opening, the second pixel opening and the third pixel opening are configured to be arranged in at least one of following ways:
a plane of symmetry of the two adjacent data signal lines is taken as a plane of symmetry, the first pixel opening is mirror-symmetric; or
another plane of symmetry of the another two adjacent data signal lines is taken as another plane of symmetry, the second pixel opening is mirror-symmetric; or
yet another plane of symmetry of the yet another two adjacent data signal lines is taken as yet another plane of symmetry, the third pixel opening is mirror-symmetric.

18. The display panel according to any one of claims 2 to 17, further comprising:
a first planarization layer, a conductive connection layer and a second planarization layer that are located between the circuit structure layer and the first electrode layer and sequentially away from the substrate; wherein the first planarization layer has a plurality of first via holes therein, the conductive connection layer includes a plurality of conductive portions, and the second planarization layer has a plurality of second via holes therein;
the display panel has a plurality of sub-pixel regions; in a sub-pixel region,
a first electrode is electrically connected to a conductive portion through a second via hole, and the conductive portion is electrically connected to a pixel driving circuit through a first via hole; and
a minimum distance between an orthogonal projection of a border of the first via hole on the substrate and an orthogonal projection of a pixel opening on the substrate is less than a minimum distance between an orthogonal projection of a border of the second via hole on the substrate and the orthogonal projection of the pixel opening on the substrate.

19. The display panel according to claim 18, wherein
in the two adjacent rows of pixel openings, first via holes respectively corresponding to all pixel openings are arranged on a straight line extending in the first direction, and second via holes respectively corresponding to all the pixel openings are alternately arranged, in the first direction, on both sides of the straight line extending in the first direction.

20. The display panel according to claim 19, wherein
in the two adjacent rows of pixel openings, the first via holes respectively corresponding to all the pixel openings are each located at a same position in a respective pixel driving circuit; and
the second via holes respectively corresponding to the first pixel openings and second via holes respectively corresponding to the second pixel openings are each located at a same position in a respective pixel driving circuit.

21. The display panel according to claim 19, wherein
in the two adjacent rows of pixel openings, positions of the first via holes respectively corresponding to all the pixel openings are different in the second direction;
the display panel further comprises light-emitting control signal lines located in a first gate layer and extending in the first direction, an orthogonal projections of each first via hole on the substrate has an approximately equal overlapping area with an orthographic projection of a respective light-emitting control signal line on the substrate.

22. The display panel according to any one of claims 18 to 21, wherein
in a same column of pixel openings, first via holes respectively corresponding to all pixel openings and second via holes respectively corresponding to all the pixel openings are arranged on a straight line extending in the second direction.

23. A display apparatus, comprising:
the display panel according to any one of claims 1 to 22.
